(19) Europäisches Patentamt / European Patent Office / Office européen des brevets

(11) EP 3 132 475 B1

(12) **EUROPÄISCHE PATENTSCHRIFT**

(45) Veröffentlichungstag und Bekanntmachung des Hinweises auf die Patenterteilung:
**28.03.2018 Patentblatt 2018/13**

(21) Anmeldenummer: **15717151.3**

(22) Anmeldetag: **14.04.2015**

(51) Int Cl.:
***H01L 51/54*** $^{(2006.01)}$ ***C07F 1/08*** $^{(2006.01)}$
***C09K 11/06*** $^{(2006.01)}$

(86) Internationale Anmeldenummer:
**PCT/EP2015/058034**

(87) Internationale Veröffentlichungsnummer:
**WO 2015/158693 (22.10.2015 Gazette 2015/42)**

(54) **METALLKOMPLEXE ALS EMITTERMATERIALIEN**

METAL COMPLEXES AS EMITTER MATERIALS

COMPLEXES MÉTALLIQUES COMME MATÉRIAUX ÉMETTEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **15.04.2014 EP 14164815**
**05.09.2014 EP 14183851**

(43) Veröffentlichungstag der Anmeldung:
**22.02.2017 Patentblatt 2017/08**

(73) Patentinhaber: **cynora GmbH**
**76646 Bruchsal (DE)**

(72) Erfinder:
- **VOLZ, Daniel**
**76137 Karlsruhe (DE)**
- **ZINK, Daniel**
**76646 Bruchsal (DE)**
- **FRIEDRICHS, Jana**
**76137 Karlsruhe (DE)**

(74) Vertreter: **Hoppe, Georg Johannes**
**Darani Anwaltskanzlei**
**Beuckestrasse 20**
**14163 Berlin (DE)**

(56) Entgegenhaltungen:
**WO-A1-2010/149748 WO-A1-2013/014066**

- **VOLZ DANIEL ET AL: "Small change, big red shift: syntheses, structure and photoluminescence of Cu2Br2(Ph3P)2py2(py=pyridine, 4-vinylpyridine)", INORGANIC CHEMISTRY COMMUNICATIONS, Bd. 37, 23. September 2013 (2013-09-23), Seiten 106-109, XP028774965, ISSN: 1387-7003, DOI: 10.1016/J.INOCHE.2013.09.023**
- **DANIEL M. ZINK ET AL: "Heteroleptic, Dinuclear Copper(I) Complexes for Application in Organic Light-Emitting Diodes", CHEMISTRY OF MATERIALS, Bd. 25, Nr. 22, 17. Oktober 2013 (2013-10-17), Seiten 4471-4486, XP055159310, ISSN: 0897-4756, DOI: 10.1021/cm4018375**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 132 475 B1

## Beschreibung

Die Erfindung betrifft Metallkomplexe (Emittermaterialien) und deren Verwendung als Emitter in optoelektronischen Bauelementen, insbesondere in OLEDs (organischen licht-emittierenden Dioden), sowie als Sensoren.

## Einleitung

Die auf OLED (Organic Light Emitting Diodes) basierende Technologie hat sich in den letzten Jahren im Bereich von Beleuchtungs- und Displayapplikationen als kostengünstige und energieeffiziente Technik durchgesetzt. Entsprechende Produkte sind bereits heute kommerziell erhältlich und werden in verschiedensten Arten von opto-elektronischen Bauelementen eingesetzt.

In der Regel sind derartige Bauteile in Schichtstrukturen realisiert, welche überwiegend aus organischen Materialien bestehen. Zum besseren Verständnis ist in Figur 1A/B ein vereinfachter Aufbau exemplarisch dargestellt. Herzstück solcher Bauteile ist die Emitterschicht, welche typischerweise zwischen einer Anode und einer Kathode angeordnet ist und die in der Regel aus einem Hostmaterial besteht, in welches die emittierenden Moleküle eingebettet sind. Weitere Schichten, wie die Lochinjektionsschicht, die Lochtransportschicht, die Elektronenleitschicht und die Zwischenschicht bewirken im Allgemeinen eine dramatisch verbesserte Effizienz der Bauteile. Bei Anlegen eines Stroms/einer Spannung treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Die in OLEDs verwendeten Emitter-Moleküle können in verschiedener Weise realisiert werden. So kommen sowohl rein organische, metall-organische Moleküle als auch Komplexverbindungen zum Einsatz. Hierbei sind besonders die metallorganischen Substanzen, die sog. Triplett-Emitter, von Interesse, bei deren Verwendung in OLEDs im Allgemeinen besonders hohe Lichtausbeuten realisiert werden können. Unter Einsatz von metallorganischen Komplexen mit hoher Emissionsquantenausbeute (Übergänge unter Einbeziehung der untersten Triplett-Zustände zu den Singulett-Grundzuständen) lässt sich zudem eine besonders hohe Effizienz des Bauteils erzielen. Aufgrund dieser Eigenschaften kommt der Weiterentwicklung der metall-organischen Materialien ein wesentlicher Stellenwert zu. Wichtig hierbei ist, dass sich in diesen Materialien die optischen Eigenschaften in einfacher Weise einstellen lassen. Bis heute ist es schwierig, mit bekannten OLED-Emittern sämtliche für die Displayfertigung wichtigen Emissionsfarben zur Verfügung zu stellen.

Zweikernige Kupferkomplexe der Form $Cu_2X_2L_4$, $Cu_2X_2L_2L'_2$, $Cu_2X_2L_2L''$ und $Cu_2X_2L''_2$ (L und L' = Phosphan-, Amin-, Imin-Ligand; L" = zweizähniger Phosphan-, Amin-, Imin- oder P∩N-Ligand) sind bereits aus dem Stand der Technik bekannt (D. Volz et al, Inorg. Chem. Commun. 2013, 37, 106; H. Araki, K. Tsuge, Y. Sasaki, S. Ishizaka, N. Kitamura, Inorg. Chem. 2007, 46, 10032; D. M. Zink et al, Chem. Mat. 2013, 25, 4471; WO2010149748 A1; WO2013014066 A1). Sie zeigen intensive Lumineszenz bei Anregung mit UV-Licht. Dennoch sind nicht alle genannten derartigen Kupferkomplexe für die Anwendung als Emitter in OLEDs geeignet. So können die in D. Volz et al, Inorg. Chem. Commun. 2013, 37, 106 gezeigten $Cu_2X_2L_2L'_2$-Komplexe aufgrund mangelnder Stabilität nicht aus der Gasphase abgeschieden werden. Auch für das nasschemische Prozessieren sind sie nicht geeignet. So dissoziieren sie in Lösung durch das Vorhandensein ausschließlich monodentater Liganden, sprich das Fehlen von Brücken bzw. die flüchtigen Liganden würden beim Trocknen unter vermindertem Druck, wie es bei der Herstellung von OLEDs nötig ist um das Prozessierungslösungsmittel zu entfernen, abgespalten werden.

Bei Komplexen, wie den $Cu_2X_2L_2L''$-Komplexen aus D. M. Zink et al, Chem. Mat. 2013, 25, 4471 und WO2010149748 A1 oder den $Cu_2X_2L''_2$-Kupferkomplexen (WO 2013014066 A1) ist problematisch, dass sich die $Cu_2X_2L_2L''$-Komplexe nicht verdampfen lassen. Auch die $Cu_2X_2L''_2$-Kupferkomplexe können nur nasschemisch prozessiert werden. Um effiziente, langlebige OLEDs herzustellen, sollte jedoch die Verdampfung, der derzeitige Industriestandard in der OLED-Fertigung, realisiert werden können.

Ein weiteres Problem bei der Verwendung von bisher bekannten zweikernigen Cu-Emittern in OLEDs ist deren thermische Stabilität. So degradieren bekannte Emitter bereits bei Temperaturen unterhalb von 200 °C (D. Volz et al., Chem. Mater. 2013, 25, 3414) und sind somit für die Anwendung im Bauteilbetrieb wenig geeignet.

Weitere Nachteile und Probleme von OLEDs mit bisher bekannten zweikernigen Cu-Emittern zeigen sich zudem in folgenden Bereichen:

- Langzeitstabilität der Emitter in den OLED-Devices,
- Chemische Stabilität gegenüber Wasser und Sauerstoff, sowie Säuren wie PEDOT:PSS,
- Fertigungstechnische Reproduzierbarkeit (siehe Beispiel 4),
- Erreichbarkeit einer hohen Effizienz bei hohen Stromdichten,

- Erreichbarkeit sehr hoher Leuchtdichten.

Die der Erfindung zu Grunde liegende Aufgabe besteht somit in der Bereitstellung neuer Emittermaterialien mit verbesserten Eigenschaften, wobei zumindest einige der oben genannten Nachteile überwunden werden.

**Beschreibung**

Es wurden überraschend neue Emittermaterialien gefunden.

Die erfindungsgemäßen Moleküle umfassen zweikernige Metallkomplexe, aufweisend eine Struktur gemäß Formel A oder bestehend aus einer Struktur gemäß Formel A

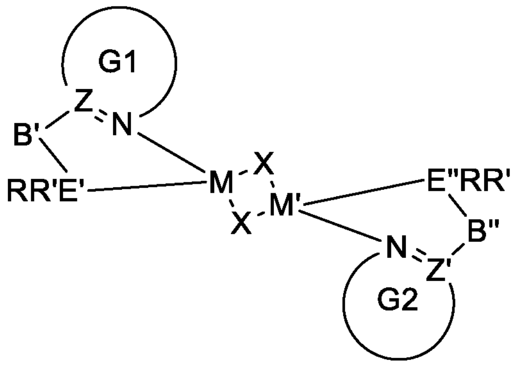

**Formel A**

wobei

M/M' = unabhängig ausgewählt aus der Gruppe bestehend aus Cu, Ag, Au;
X = unabhängig ausgewählt aus der Gruppe bestehend aus Cl, Br, I, Pseudohalogenide; E'/E" = unabhängig ausgewählt aus der Gruppe bestehend aus P, As;
Z/Z' = unabhängig ausgewählt aus der Gruppe bestehend aus N oder C; wobei zwischen Z/Z' und N entweder eine Einfachbindung oder eine Doppelbindung vorhanden ist;
B'/B" = unabhängig voneinander Brücke mit mindestens 2 bis zu 17 Gliedern; die Glieder können bestehen aus $CH_2$, CHR'", CR'"R"", O, S, Se, NR'", PR'", AsR'", wobei R'" ein Rest ausgewählt aus der Gruppe bestehend aus Alkyl, Aryl, Hereroaryl, OR, SR, SeR, H, D ist;
G1/G2 = unabhängig voneinander fünf oder sechsgliedriges, heteroaromatisches Ringsystem, welches optional mit weiteren Resten wie R/R' substituiert oder mit weiteren aromatischen Ringen anneliert ist; einer der Reste an G1/G2 kann auch eine weitere Brücke sein, die eine Brücke wie B'/B" aufspannt; durch diese Brücke wird das Ringsystem G1 mit dem Donoratom E" und das Ringsystem G2 mit dem Donoratom E' verbunden;
jedes R und R' ist bei jedem Auftreten gleich oder verschieden H, Deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination dieser Systeme; dabei können zwei oder mehrere dieser Substituenten R und R' auch miteinander ein mono- oder polycyclisches, aliphatisches, aromatisches und/oder benzoannelliertes Ringsystem bilden;
$R^2$ bei jedem Auftreten gleich oder verschieden ist H, Deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^3$ substituiert sein kann, wobei eine oder mehrere nicht benachbarte $CH_2$-Gruppen durch $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^3$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;
$R^3$ bei jedem Auftreten gleich oder verschieden ist H, Deuterium, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

Die Metallkomplexe der Formel A weisen somit zweizähnige Liganden E'∩N und E"∩N der nachfolgenden Strukturen auf

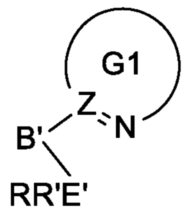

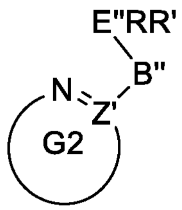

E’∩N E”∩N

wobei die für Formel A angegebenen Definitionen gelten.

In einer Ausführungsform der Erfindung ist B’/B" eine organische Brücke mit mindestens 2 bis zu 17 Gliedern, die eine substituierte oder unsubstituierte Alkylen-, Alkenylen-, Alkinylen- oder Arylen-Gruppe oder eine Kombination dieser, oder -O-, -NR-, $-C=CR_2$, -C=NR, $-SiR_2$-S-, -S(O)-, $-S(O)_2$-, durch O unterbrochene Alkyl- (auch verzweigt oder zyklisch), Heteroalkyl-, Aryl-, Heteroaryl-, Alkenyl-Gruppen, Phenyl- und substituierte Phenyleinheiten ist.

In einer weiteren Ausführungsform ist B’/B" eine bivalente organische Brücke, die eine substituierte oder unsubstituierte Alkylen- (auch verzweigt oder zyklisch), Alkenylen-, Alkinylen-, Arylen-, Heteroarylen-Gruppe, O, NR, $C=CR_2$, C=NR, $SiR_2$ S, S(O), $S(O)_2$, BR, PR, P(O)R, oder eine Kombination dieser Einheiten ist (z. B. durch O unterbrochene Alkylen-(auch verzweigt oder zyklisch), Alkenylen-, Alkinylen-, Arylen- und Heteroarylen-Gruppen).

In einer weiteren Ausführungsform sind die Brücken B’ und B" unabhängig voneinander ausgewählt aus einer der folgenden Strukturen:

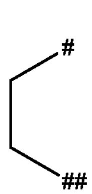 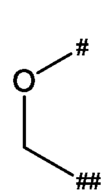 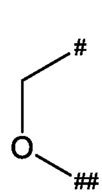 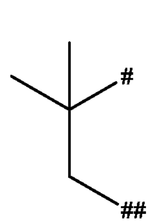 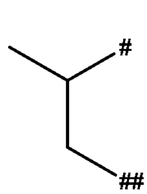

wobei # die Verbindungsstelle zu Z/Z’ und ## die Verbindungsstelle zu E’/E" angibt.

In einer Ausführungsform weisen die zweikernigen Metallkomplexe der Formel A eine Struktur gemäß Formel A’ auf:

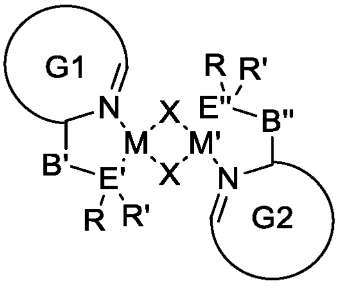

**Formel A'**

wobei die gleichen Definitionen wie für Formel A gelten.

In einer weiteren Ausführungsform ist das Ringsystem G1/G2 unabhängig voneinander ausgewählt aus der Gruppe bestehend aus einer ungesättigten oder aromatischen N-heterozyklischen Einheit mit 5 bis 6 Ring-Atomen, die ausgewählt ist aus der Gruppe bestehend aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die mit einem oder mehreren Resten R substituiert sein können, wobei zwei oder mehr Reste R miteinander verknüpft sein können und einen Ring bilden können, wobei die Reste R zusammen mit dem zentralen 5- bis 6-Ring auch anellierte Ringsysteme ausbilden können,
wobei die Koordination an das M/M'-Atom über ein Stickstoffatom der N-heterozyklischen Einheit stattfindet:

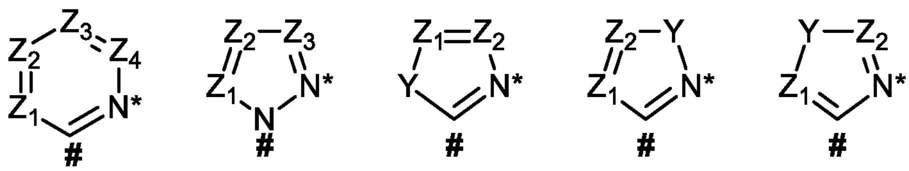

mit

(Verknüpfung zu B' und zu B" findet an der mit # gekennzeichneten Stelle statt, * kennzeichnet das Atom, das die Komplexbindung eingeht)

$Z^1$-$Z^4$ = jeweils unabhängig voneinander ausgewählt aus der Gruppe bestehend aus dem Fragment CR und N, mit

R ist bei jedem Auftreten gleich oder verschieden H, Deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden;

$R^2$ bei jedem Auftreten gleich oder verschieden ist H, Deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^3$ substituiert sein kann, wobei eine oder mehrere nicht benachbarte $CH_2$-Gruppen durch $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^3$ substituiert sein kann, oder eine Aryloxy- oder Heteroaryloxygruppe mit 5 bis 60 aromatischen Ringatomen, die durch einen oder mehrere Reste

$R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;
$R^3$ bei jedem Auftreten gleich oder verschieden ist H, Deuterium, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

In einer Ausführungsform ist $R^3$ ein organischer Rest, der unabhängig voneinander ausgewählt ist aus der Gruppe bestehend aus Wasserstoff, Halogen und Substituenten, die direkt oder über Sauerstoff- (-OR), Stickstoff- ($-NR_2$), Silizium- ($-SiR_3$) oder Schwefelatome (-SR) gebunden sind sowie Alkyl- (unverzweigt, verzweigt oder zyklisch), Heteroalkyl-, Aryl-, Heteroaryl-, Alkenyl-, Alkinyl-Gruppen bzw. substituierte Alkyl- (unverzweigt, verzweigt oder zyklisch), Heteroalkyl-, Aryl-, Heteroaryl- und Alkenyl-Gruppen (mit Substituenten wie Halogene oder Deuterium, Alkylgruppen (unverzweigt, verzweigt oder zyklisch), Heteroalkyl-, Aryl-, Heteroarylgruppen), und weitere allgemein bekannte Donor- und Akzeptor-Gruppen, wie beispielsweise Amine, Carboxylate und deren Ester, und $CF_3$-Gruppen, die optional weiter substituiert und/oder anneliert sind. Die Reste $R^3$ führen optional auch zu annelierten Ringsystemen.

Die Komplexstrukturen können, zwei, drei oder vier Brücken aufweisen. In einer Ausführungsform weisen die zweikernigen Metallkomplexe der Formel A zwei Brücken auf:

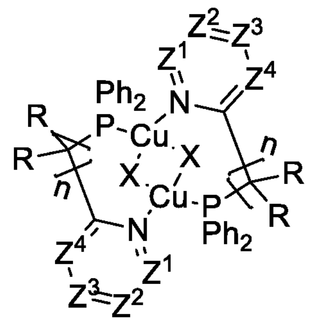

X = Cl, Br, I,
n = 2 - 4

wobei die gleichen Definitionen wie für Formel A gelten, und wobei in einer Ausführungsform $Z^1$ bis $Z^4$ gleich CR sind.

In einer weiteren Ausführungsform weisen die zweikernigen Metallkomplexe der Formel A drei Brücken auf:

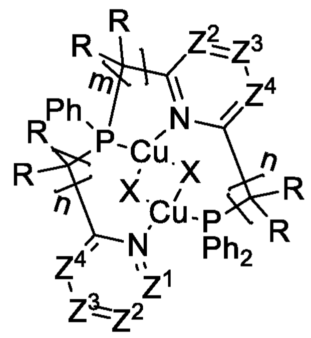

X = Cl, Br, I,
n = 2 - 4
m = 2 - 4

wobei die gleichen Definitionen wie für Formel A gelten, und wobei in einer Ausführungsform $Z^1$ bis $Z^4$ gleich CR sind.

In einer weiteren Ausführungsform weisen die zweikernigen Metallkomplexe der Formel A vier Brücken auf:

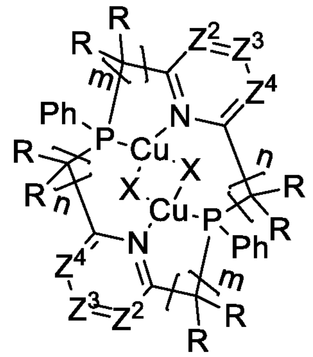

X = Cl, Br, I,
n = 2- 4
m = 2-4

wobei die gleichen Definitionen wie für Formel A gelten, und wobei in einer Ausführungsform $Z^2$ bis $Z^4$ gleich CR sind.

In einer weiteren Ausführungsform weisen die zweikernigen Metallkomplexe der Formel A eine Struktur gemäß Formel B auf:

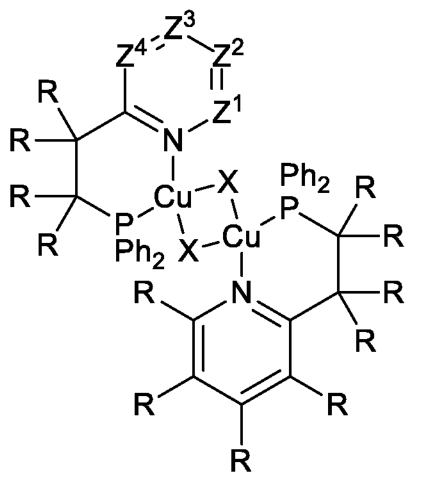

**Formel B**

wobei die gleichen Definitionen wie für Formel A gelten, und wobei in einer Ausführungsform $Z^1$ bis $Z^4$ gleich CR sind.

In einer weiteren Ausführungsform weisen die zweikernigen Metallkomplexe der Formel A folgende Strukturen auf:

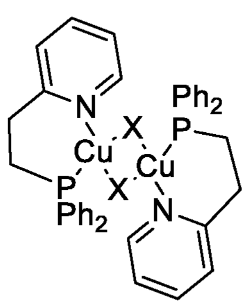
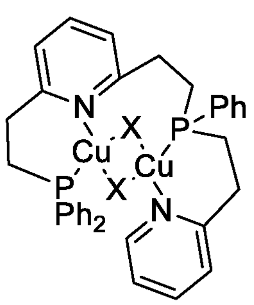
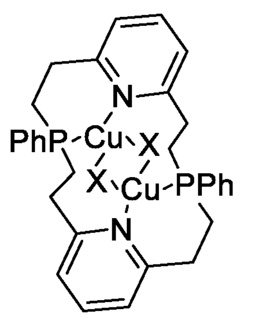

X = Cl, Br, I

In einer weiteren Ausführungsform weisen die Liganden E'∩N und E"∩N für Komplexe mit 2 Brücken unabhängig voneinander folgende Strukturen auf:

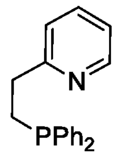
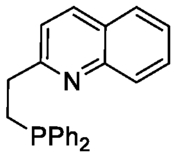
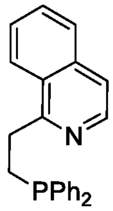
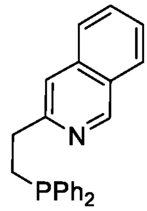

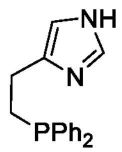
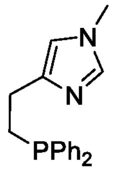
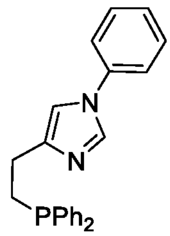
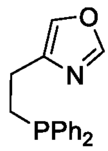
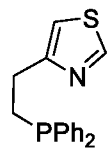
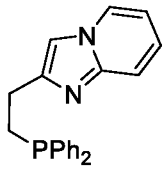

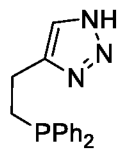
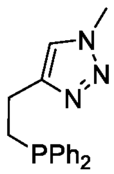
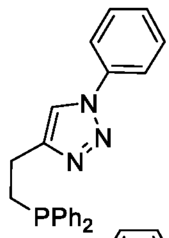
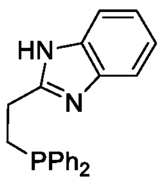
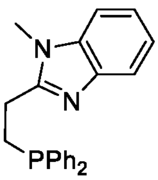
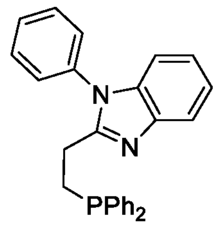

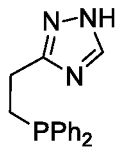
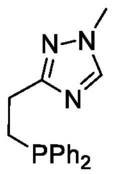
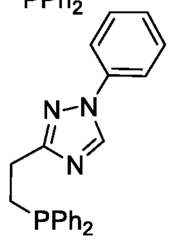

Die Erfindung erlaubt die Verwendung der Basis-artigen Komplexe in OLEDs, insbesondere als blaue Emitter. In einer Ausführungsform der Erfindung weisen die Komplexe die nachfolgenden Strukturen auf:

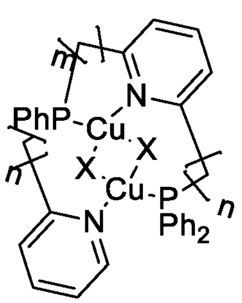
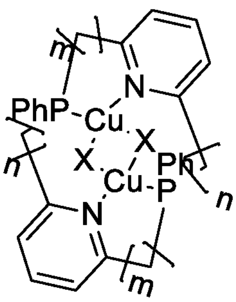

Für die beiden obigen Strukturen wurden Dichtefunktionaltheorie basierte Rechnungen (DFT-Rechnungen) durchgeführt. Der Komplex mit m=2, n=2 und X=Br, sowie der Komplex mit m = 3, n=3 und X=Br ist laut DFT-Rechnungen intrinsisch stabil und zeigt einen dem Basis-System ähnlichen MXLCT-Übergang.

Ein weiterer Aspekt der Erfindung betriff die Veränderung der Emissionsfarben der Kupferkomplexe mittels elektronenschiebender oder -ziehender Substituenten oder mittels kondensierter N-Heteroaromaten. Die Begriffe elektronenschiebend und elektronenziehend sind dem Fachmann bekannt.

Beispiele für elektronenschiebende Substituenten sind insbesondere:

-Alkyl, -Phenyl, $-CO_2(-)$, -O(-), -NH-Alkylgruppe, $-N-(Alkylgruppe)_2$, $-NH_2$, -OH, -O-Alkylgruppe, -NH(CO)-Alkylgruppe, -O(CO)-Alkylgruppe, -O(CO)-Arylgruppe, -O(CO)-Phenylgruppe, $-(CH)=C-(Alkylgruppe)_2$, -S-Alkylgruppe

Beispiele für elektronenziehende Substituenten sind insbesondere:

-Halogen, -(CO)H, -(CO)-Alkylgruppe, -(CO)O-Alkylgruppe, -(CO)OH,-(CO)Halogenid, $-CF_3$, -CN, $-SO_3H$, $-NH_3(+)$, $-N(Alkylgruppe)_3(+)$, $-NO_2$

Vorteilhafter Weise sind die elektronenschiebenden und -ziehenden Substituenten möglichst weit von der Koordinationsstelle des Liganden entfernt, insbesondere in meta- oder paraStellung des fünf oder sechsgliedrigen, heteroaromatischen Ringsystems G1/G2.

Elektronenschiebende Substituenten führen durch Erhöhung des LUMOs zur Veränderung der Emissionsfarbe der Kupfer(I)komplexe in Richtung des blauen Spektralbereichs. Elektronenziehende Substituenten führen durch Absenkung des LUMOs zur Veränderung der Emissionsfarbe der Kupfer(I)komplexe in Richtung des gelbroten Spektralbereichs. Somit kann durch geeignete Substitutionswahl innerhalb der Grundstruktur eines fünf oder sechsgliedrigen, heteroaromatischen Ringsystems G1/G2 ein sehr breiter Emissionsfarbbereich eingestellt werden.

Die Veränderung der Emissionsfarben der hier beschriebenen Kupfer(I)komplexe kann auch durch weitere Heteroatome wie N, O, S, sowie mittels kondensierter N-, O- und S-Heteroaromaten erfolgen. Die Verwendung kondensierter N-Heteroaromaten (beispielsweise Isoquinolin, Benzothiazol, Chinoxalin) ermöglicht Farbverschiebungen, zum Beispiel in den gelben bis tiefroten Spektralbereich.

Die erfindungsgemäßen Komplexe weisen überraschenderweise gegenüber dem Stand der Technik erhöhte chemische und thermische Stabilitäten auf. Durch das Vorhandensein ausschließlich bidentater Liganden treten weniger leicht Dissoziationsprozesse auf. Dies schlägt sich beispielsweise in der thermischen Stabilität der Komplexe nieder, die erst bei Temperaturen um die 400 °C thermisch degradieren, wie Thermogravimetrie-Messungen (TGA, thermogravimetrische Analyse) zeigen (Figur 2). Für vergleichbare Komplexe aus dem Stand der Technik tritt dieser Vorgang bereits unterhalb von 200 °C auf (D. Volz, Chem. Mater. 2013, 25, 3414). Entsprechend lassen sich die erfindungsgemäßen Verbindungen beispielsweise unter Laborbedingungen sublimieren, etwa bei Drücken um $10^{-5}$ mbar und Temperaturen von 240 °C.

In einem weiteren Aspekt betrifft die Erfindung ein Verfahren zur Herstellung eines zweikernigen Metallkomplexes der hier beschriebenen Art, aufweisend den Schritt der Substitution mindestens eines Liganden E'∩N oder E"∩N (oder beider Liganden) mit mindestens einer funktionellen Gruppe zur Verbesserung des Ladungsträgertransports, die ausgewählt ist aus Elektronenleiter und Lochleiter.

In einem weiteren Aspekt betrifft die Erfindung die Verwendung des erfindungsgemäßen Metallkomplexes der Formel A als Emitter oder Absorber in einem optoelektronischen Bauelement, das durch ein Vakuumverdampfungsverfahren oder aus Lösung hergestellt wird. Die Möglichkeit der Vakuum-Prozessierung lässt sich hierbei durch die Inversions-Symmetrie der erfindungsgemäßen Komplexe begründen. Insbesondere die Punktsymmetrie der erfindungungsgemäßen Komplexe ist gegenüber dem Stand der Technik von Vorteil, da zwischenmolekulare Wechselwirkungen minimiert werden. Durch die hohe Symmetrie sind Polarisierbarkeit klein und das Dipolmoment weist den Wert 0 auf; in diesem Fall bestehen im Festkörper weniger Wechselwirkung zwischen den einzelnen Molekülen und die Verbindungen lassen sich leichter aus dem Kristallverband lösen und verdampfen.

Das optoelektronische Bauelement kann ausgewählt sein aus der Gruppe bestehend aus:

- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- Organischen Solarzellen,
- Organischen Feldeffekttransistoren,
- Organischen Lasern und
- Down-Konversions-Elementen.

Der Anteil des Metallkomplexes am Emitter oder Absorber beträgt in einer Ausführungsform der Anwendung 100 %. In einer alternativen Ausführungsform beträgt der Anteil des Metallkomplexes am Emitter oder Absorber 1 % bis 99 %. In einer Ausführungsform der Erfindung beträgt der Anteil des Metall(I)komplexes als Emitter in optischen Licht emittierenden Bauelementen, insbesondere in OLEDs, zwischen 5 % und 80 %.

In einem weiteren Aspekt betrifft die Erfindung ein optoelektronisches Bauelement, aufweisend einen erfindungsgemäßen Metallkomplex der hier beschriebenen Art. Das optoelektronisches Bauelement kann ausgeformt sein als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

In einer Ausführungsform des optoelektronischen Bauelements wird der erfindungsgemäße Metallkomplex als Emissionsmaterial in einer Emissionsschicht des Bauelements eingesetzt, wobei er entweder als Reinschicht oder in

Kombination mit einem Matrixmaterial eingesetzt ist.

Der Anteil des Metallkomplexes als Emissionsmaterial in einer Emissionsschicht in optischen Licht emittierenden Bauelementen, insbesondere in OLEDs, beträgt in einer Ausführungsform zwischen 5 % und 80 %.

Das Matrixmaterial für den erfindungsgemäßen Metallkomplex ist ausgewählt ist aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, Silanen, Azaborolen, Boronestern, Triazinderivaten, Zinkkomplexen, Diazasilol- bzw. Tetraazasilol-Derivaten, Benzophenonderivaten, Diphenylmethanderivate, Ultra-High-Energy-Gap-Matrixmatrialien (UHG-Matrixmaterialien oder Wide-Gap-Matrixmaterialien genannt, wobei der Energieabstand S0-T1 des Matrixmaterials mindesten 10 meV, insbesondere 50 meV und bevorzugt mindestens 100 meV größer ist als der Energieabstand S0-T1 eines eindotierten Metallkomplexes.) oder Mischungen aus zwei oder mehr dieser Matrixmaterialien.

In einer Ausführungsform weist das optoelektronische Bauelement ein Substrat und mindestens eine lichtemittierende Schicht auf, die einen hier beschriebenen Metallkomplex aufweist, wobei die lichtemittierende Schicht auf das Substrat aufgebracht ist.

In einer weiteren Ausführungsform weist das optoelektronische Bauelement ein Substrat, eine Anode, eine Kathode und mindestens eine lichtemittierende Schicht auf, die einen hier beschriebenen Metallkomplex aufweist, wobei die Anode und die Kathode auf das Substrat aufgebracht ist und die lichtemittierende Schicht zwischen Anode und Kathode aufgebracht ist.

Gemäß einer weiteren Ausführungsform weist das optoelektronische Bauelement ein Substrat, eine Anode, eine Kathode und mindestens eine lichtemittierende Schicht auf, die ausschließlich einen Metallkomplex in 100 % Konzentration aufweist, wobei die Anode und die Kathode auf das Substrat aufgebracht ist, und die lichtemittierende Schicht zwischen Anode und Kathode aufgebracht ist.

Das optoelektronische Bauelement weist in einer Ausführungsform ein Substrat, eine Anode, eine Kathode und mindestens eine lichtemittierende Schicht auf, die einen Metallkomplex der hierin beschriebenen Art und ein Hostmaterial aufweist, dessen Triplett (T1)- und Singulett (S1)-Energieniveaus energetisch höher liegen als die Triplett (T1)- und Singulett (S1)-Energieniveaus des Metallkomplexes, wobei die Anode und die Kathode auf das Substrat aufgebracht sind und die lichtemittierende Schicht zwischen Anode und Kathode aufgebracht ist.

In einer weiteren Ausführungsform weist das optoelektronische Bauelement mindestens je eine löcher- und elektroneninjizierende Schicht, und mindestens je eine löcher- und elektronentransportierende Schicht auf, wobei die löcher- und elektroneninjizierende Schicht zwischen Anode und Kathode aufgebracht ist, und die löcher- und elektronentransportierende Schicht zwischen der löcher- und der elektroneninjizierenden Schicht aufgebracht ist, und die lichtemittierende Schicht zwischen löcher- und elektronentransportierende Schicht aufgebracht ist.

In einem weiteren Aspekt betrifft die Erfindung ein Verfahren zur Herstellung eines optoelektronischen Bauelements, wobei ein Metallkomplex der hierin beschriebenen Art verwendet wird.

In einer Ausführungsform des Verfahrens wird der Metallkomplex auf einen Träger aufgebracht. Das Aufbringen kann nass-chemisch, mittels kolloidaler Suspension oder mittels Sublimation erfolgen.

In einem weiteren Aspekt betrifft die Erfindung ein Verfahren zur Veränderung der Emissions- und/oder Absorptionseigenschaften eines elektronischen Bauelements, wobei ein Metall(I)komplex der hier beschriebenen Art in ein Matrixmaterial zur Leitung von Elektronen oder Löchern eines optoelektronischen Bauelements eingebracht wird.

In einem weiteren Aspekt betrifft die Erfindung ein Verfahren zur Herstellung eines optoelektronischen Bauelements der beschriebenen Art in Form einer organischen Elektrolumineszenzvorrichtung. Dabei werden eine oder mehrere Schichten mit einem Sublimationsverfahren, oder mit einem OVPD (Organic Vapour Phase Deposition) Verfahren, oder mit Hilfe einer Trägergassublimation oder mit einem beliebigen Druckverfahren beschichtet.

In einem weiteren Aspekt betrifft die Erfindung die Verwendung eines erfindungsgemäßen Metallkomplexes, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

In einem weiteren Aspekt betrifft die Erfindung eine Zusammensetzung, aufweisend einen erfindungsgemäßen Metallkomplex und ein Hostmaterial, wobei die Triplett (T1)- und Singulett (S1)-Energieniveaus des Hostmaterials energetisch höher liegen als die Triplett (T1)- und Singulett (S1)-Energieniveaus Metallkomplexes, und wobei der Metallkomplex Fluoreszenz oder thermisch aktivierte verzögerte Fluoreszenz zeigt, und einen deltaE(S1-T1)-Wert zwischen dem untersten angeregten Singulett (S1)- und dem darunter liegenden Triplett (T1)-Zustand von kleiner als 2000 $cm^{-1}$ aufweist.

In einem weiteren Aspekt betrifft die Erfindung ein Verfahren zur Veränderung der Emissions- und/oder Absorptionseigenschaften eines elektronischen Bauelements, wobei eine erfindungsgemäßer Metallkomplexe mittels Vakuumverdampfung in ein gegebenes Bauelement mit gegebenen Emissions- und/oder Absorptionseigenschaften eingebracht wird, so dass sich die Emissions- und/oder Absorptionseigenschaften ändern.

**Beispiele**

Allgemeine Synthesevorschrift:

**AAV 2: Herstellung von Komplexen ohne Ultraschallbehandlung ($Cu_2X_2(N^{**},P^{**})_2$** Das entsprechende Kupfersalz (1.00 Äquiv., 1.00 mmol), die Liganden (1.50 Äquiv., 1.50 mmol;) werden unter Stickstoff in einem 20 mL Crimp-Vial mit Rührfisch vorgelegt. Die Mischung wird mit 10 mL trockenem Dichlormethan versetzt. Die Reaktion wird gerührt bis eine klare, zumeist gelbe Lösung vorlag. Die Reaktionsmischung wurde über einen Spritzenfilter (0.45 μm) filtriert und in mind. 50-fachem Volumenüberschuss Methanol, Diethylether oder n-Hexan ausgefällt. Die Produkte wurden abfiltriert und unter vermindertem Druck getrocknet.

**Beispiel 1** *Synthese von (2-(2-Diphenylphosphino)-ethyl-pyridin)$_2Cu_2Cl_2$* (**10-Cl**)

Der Komplex wurde nach der allgemeinen Synthesevorschrift in MeCN hergestellt und aus heißem MeCN kristallisiert. Der Komplex wurde filtriert und am Vakuum getrocknet. Gelbe Kristalle (70% Ausbeute). FAB-MS *m/z* (%): 778 [$M^+$], 745 [M-$Cl^+$], 645 [M-Cl-$L^+$], 454 [M-L-$Cl^+$], 389 [M-CuL$Cl^+$], 354 [M-$CuCl_2L^+$]. - IR (ATR) 3044 (vw), 1593 (w), 1562 (vw), 1475 (m), 1448 (w), 1432 (s), 1310 (vw), 1262 (vw), 1184 (vw), 1096 (m), 1069 (w), 1025 (vw), 1009 (w), 898 (vw), 871 (m), 771 (s), 743 (vs), 694 (vs), 694 (vs), 675 (s), 636 (w), 522 (s), 503 (s), 478 (s), 414 (m) $cm^{-1}$. - $C_{38}H_{36}N_2P_2Cu_2Cl_2$: ber. C 58.47; H 4.65; N 3.59; gef. C 58.43, H 4.64, N 3.20.

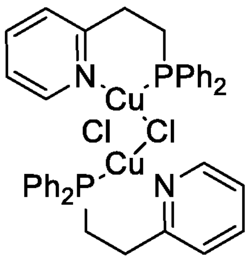

**10-Cl**

**Beispiel 2** *Synthese von (2-(2-Diphenylphosphino)-ethyl-pyridin)$_2Cu_2Br_2$* (**10-Br**)

Der Komplex wurde nach der allgemeinen Synthesevorschrift in MeCN hergestellt und aus heißem MeCN kristallisiert. Der Komplex wurde filtriert und am Vakuum getrocknet. Gelbe Kristalle (90% Ausbeute). - $^1H$ NMR (500 MHz, Chloroform-*d*) δ = 9.05 (d, *J* = 5.6 Hz, 2H), 7.67 (ddd, *J* = 9.9, 6.2, 4.2 Hz, 10H), 7.34 (dt, *J* = 29.8, 7.5 Hz, 13H), 7.22 (dd, *J* = 7.6, 5.2 Hz, 4H), 3.12 (dt, *J* = 21.4, 6.6 Hz, 4H), 2.57 (q, *J* = 5.9 Hz, 4H) ppm. - $^{13}C$ NMR (126 MHz, Chloroform-*d*) δ = 160.7, 138.0, 133.2, 132.9, 130.0, 128.7, 124.4, 122.6, 32.4, 26.5 ppm. - $^{31}P$ NMR (202 MHz, Chloroform-*d*) δ = -12.2 ppm. - FAB-MS *m/z* (%): 870 [$M^+$], 789 [M-$Br^+$], 645 [M-Br-$L^+$], 435 [M-CuL$Br^+$], 354 [M-$CuBr_2L^+$]. - IR (ATR) 3049 (vw), 1593 (w), 1562 (vw), 1476 (m), 1430 (m), 1308 (w), 1263 (vw), 1182 (vw), 1095 (m), 1068 (w), 1024 (w), 1010 (w), 870 (m), 768 (s), 740 (vs), 692 (vs), 673 (s), 636 (m), 522 (s), 499 (s), 476 (s), 456 (m), 412 (m) $cm^{-1}$. - $C_{38}H_{36}N_2P_2Cu_2Br_2$: ber. C 52.49; H 4.17; N 3.22; gef. C 52.40, H 4.17, N 3.01.

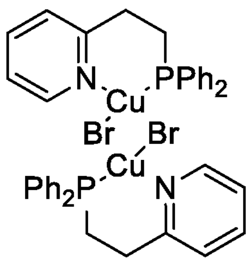

**10-Br**

Der Komplex degradiert thermisch bei ca. 400 °C (Figur 2). Die Thermogravemetrie-Messung erfolgte wie in Beispiel 5 beschrieben.

**Beispiel 3** *Synthese von (2-(2-Diphenylphosphino)-ethyl-pyridin)$_2$Cu$_2$I$_2$* (**10-I**)

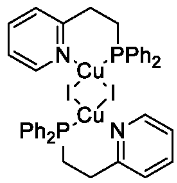

Der Komplex wurde nach der allgemeinen Synthesevorschrift in MeCN hergestellt und aus heißem MeCN kristallisiert. Der Komplex wurde filtriert und am Vakuum getrocknet. Farblose Kristalle (92% Ausbeute). - FAB-MS *m/z* (%): 836 [M-I$^+$], 645 [M-I-L$^+$], 4354 [M-CuI$_2$L$^+$]. - IR (ATR) 3045 (vw), 1598 (w), 1565 (w), 1478 (m), 1431 (s), 1406 (w), 1322 (w), 1157 (w), 1099 (w), 1017 (w), 993 (w), 932 (w), 847 (w), 778 (w), 743 (vs), 718 (s), 693 (vs), 588 (w), 520 (vw), 499 (s), 475 (m), 443 (m), 413 (m) cm$^{-1}$. - $C_{38}H_{36}N_2P_2Cu_2I_2$: ber. C 47.37; H 3.77; N 2.91; gef. C 47.40, H 3.74, N 2.78.

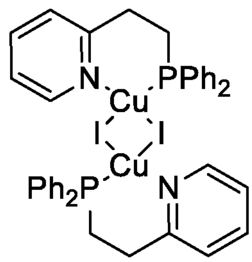

**10-i**

Die homoleptischen Komplexe **10-Cl** bis **10-I** verhalten sich analog zu vergleichbaren Komplexen , die beispielsweise in der Literatur bei Araki, H.; Tsuge, K.; Sasaki, Y.; Ishizaka, S.; Kitamura, N.; Ligands, N.; Br, N. X. Inorg. Chem. 2005, 44, 9667. beschrieben sind. Die Emissionsfarbe der Verbindungen lässt durch Austausch der Halogenide in der Reihe Cl -> Br -> I von blau nach rot verschieben.
Die HOMO-Energien von **10-Br** und **10-I** wurden mit Hilfe von Photoelektronenspektroskopie an Luft (PESA)-Messungen zu -5.30 eV und -5.43 eV bestimmt. Dies spiegelt die Lokalisierung des HOMOs auf der $Cu_2X_2$-Einheit wider: Durch den Übergang von Iod zu Brom steigt die HOMO-Energie entsprechend um ca. 0.1 eV an, was photophysikalisch zu einer Rotverschiebung der Emission führt. DFT-Rechnungen zeigen, dass die Verwendung von Ligand **10** anstelle von Pyridin **A** und Triphenylphosphin **a** die Natur des (M+X)LCT-Übergangs nicht nennenswert beeinflusst (Figur 3).

Tabelle 1: Photophysikalische Parameter der Komplexe **10-Cl, 10-Br, 10-I.**

| | $\lambda_{em}$(r.t.) [nm] | $\Delta E(S_0,S_1)$ [eV] | PLQY $\Phi$ | $\tau^a$(r.t.) [$\mu$s] | $\lambda_{em}$(77K) [nm] | $\tau^a$(77K) [$\mu$s] | $\Delta E(S_1,T_1)$ [cm$^{-1}$] |
|---|---|---|---|---|---|---|---|
| **10-Cl** | 562 | 2.54 | 0.95 | 0.49 | 590 | 32.62 | 1469 |
| **10-Br** | 540 | 2.67 | 0.76 | 0.70 | 548 | 64.77 | 1247 |
| **10-I** | 430 | 3.05 | 0.35 | 0.54 | 432 | 36.69 | 1178 |

Alle Emissionsdaten wurden an Pulverproben gemessen. Die Anregung erfolgte bei 350 nm (Emission) bzw. 377 nm ($\tau$). $\Delta E(S_0,S_1)$ = Aus Excicationsspektren nach Tauc bestimmt. $\Delta E(S_1,T_1)$ = Aus der Differenz des Emissionsonsets r.t. - 77K $^a$ = Mittelwert, triexponentieller Fit.
Tabelle 1 enthält wichtige photophysikalische Eckdaten zu den Komplexen **10-Cl, 10-Br** und **10-I.** Demnach steigen wie erwartet die Bandlücke sowie die Energie des emittierten Lichtes von Cl nach I an. Die Quanteneffizienz nimmt gleichzeitig ab, hat aber für die tiefblaue Iodoverbindung **10-I** (430 nm) noch einen sehr hohen Wert von 35 %. Aus der Emissionslebensdauer sowie dem Tieftemperaturverhalten lässt sich schließen, dass die erfindungsgemäßen Komplexe TADF-Emitter sind: Die Emissionslebensdauer ist relativ kurz, wobei bei der Interpretation der Daten beachtet werden muss, dass jeweils triexponentielle Abklingkurven erhalten und die angegebenen Lebendauern demnach Mittelwerte sind. Beim Abkühlen auf 77K steigt die Emissionslebensdauer um beinahe zwei Größenordnungen an. Nach der von Yersin vorgeschlagenen Methode wurde der Energieunterschied zwischen angeregtem Singulett und Triplett-Zustand, $\Delta E(S_1,T_1)$, aus dem Anstieg der Emissionsbande (kurzwelliger Bereich der Bande) der Emission bei Raumtemperatur

und 77K bestimmt nach Leitl, M. J.; Küchle, F. R.; Mayer, H. a; Wesemann, L.; Yersin, H. J. Phys. Chem. A 2013, 117, 11823. Der Wert sinkt in der Reihe Cl - Br - I von 1469 auf 1178 $cm^{-1}$, liegt aber für alle Verbindungen im Bereich der thermischen Energie $k_bT$ bei 300 K (ca. 240 $cm^{-1}$).

**Beispiel 4** *Test-OLEDS von 10-I, 10-Br und 10-Cl.*

Die Herstellung von OLEDs erfolgte nach einem allgemeinen Verfahren, das beispielsweise in der Anmeldung DE 10317556 A1 beschrieben ist. Dieses muss im Einzelfall auf die jeweiligen Gegebenheiten (z. B. Schichtdickenvariation, um optimale Effizienz bzw. Farbe zu erreichen) angepasst werden. Zunächst wurden Bauteile ohne die Verwendung von zusätzlichen Hostmaterialien hergestellt. Die Emissionsschicht (EML) bestand in diesen Experimenten lediglich aus Reinfilmen der Komplexe. Um Quenching durch benachbarte Grenzschichten mit niedriger Triplett-Energie zu vermeiden, wurde keine Lochleitschicht verwendet und eine zusätzliche Blockschicht aus dem bekannten Elektronentransportmaterial TSPO1 zwischen Elektronentransportschicht (ETL) und EML eingeführt. TSPO1 ist kommerziell erhältlich und verfügt über eine Triplett-Energie von 3.4 eV, sodass Quenchingprozesse hier ausgeschlossen sind.
Die Komplex **10-Cl** bis **10-I** wurden in einem OLED-Aufbau getestet, wobei ein Host-freier Reinfilm aus Kupfer(I)-komplex als EML verwendet wurde. Demnach steigt beim Übergang von Iodid nach Chlorid die HOMO-Energie von -5.3 auf -5.5 eV an. Da sich die Bandlücke näherungsweise nicht verändert, steigt die LUMO-Energie in einem vergleichbaren Umfang von -2.6 auf -2.4 eV (Figur 4). Der Aufbau der OLED war dabei wie folgt: Substrat: Glas mit ITO(130 nm)//PEDOT:PSS (30 nm)//Komplex (30 nm)//TSPO1 (15 nm)//TPBi (15 nm)//LiF(1 nm)//Al(100 nm)

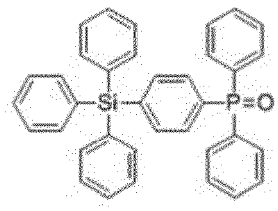

Struktur von TSPO1

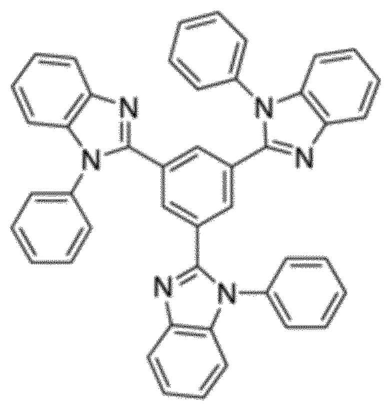

Struktur von TPBi
PEDOT:PSS = Poly(3,4-ethylenedioxythiophen)polystyrensulfonat ITO = Indium-Zinn-Oxid

Die Ergebnisse der Tests der erfindungsgemäßen Verbindungen 10-I, 10-Br und 10-Cl in einfachen OLEDs sind in Figur 5 und Tabelle 2 aufgeführt. Wie aufgrund der grundlegenden photophysikalischen Trends von CuX-Komplexen erwartet, verschiebt sich das Maximum des Elektrolumineszenzspektrums beim Übergang von Iodid nach Chlorid von 515 auf 560 nm. Die Effizienz ist beim Bromo-Komplex **10-Br** mit 5.2 lm $W^{-1}$ am höchsten in der Reihe.

Entsprechende optoelektronische Bauelemente zeigen eine im Vergleich zum Stand der Technik höhere Bauteileffizienz (Tabelle 2 und als Vergleich Tabelle 3). Die physikalischen Eigenschaften hängen bei den Komplexen des Stands der Technik ohne die erfindungsgemäßen Brücken wie dem Vergleich-Komplex E-Br-s vom verwendeten Lösungsmittel ab, was derartige Verbindungen für die praktische Anwendung unverwendbar macht. Außerdem ist, wie in Tabelle 2 aufgeführt wurde, die Bauteil-Effizienz der Verbindung 10-Br deutlich höher als die von E-Br-s.

Tabelle 2: Bauteildaten für Komplexe 10-I, 10-Br und 10-Cl.

| | $V_{on}$ (1 cd $m^{-2}$) [V] | $\eta_{CE}{}^{a}$ [cd $A^{-1}$] | $\eta_{CE}{}^{a}$ [lm $W^{-1}$] | $B^{b}$ [cd $m^{-2}$] | $\lambda_{em}$(EL) [nm] | $\lambda_{em}$(PL) [nm] | $\Phi_{EQE}{}^{a}$ |
|---|---|---|---|---|---|---|---|
| **10-I** | 3.5 | 2.8 | 1.8 | 1120 | 515 | 500 | 1.0% |
| **10-Br** | 4.2 | 10.5 | 5.2 | 1830 | 550 | 550 | 2.2% |
| **10-Cl** | 4.5 | 3.1 | 1.6 | 145 | 560 | 555 | 8.0% |

[a]= gemessen für 1 mA $cm^{-2}$. [b]= gemessen bei 12 V Einsatzspannung. Photolumineszenzspektroskopie: Anregung bei 350 nm.

Tabelle 3: Bauteildaten des Vergleich-Komplexes E-Br-s, prozessiert aus zwei verschiedenen Lösungsmitteln.

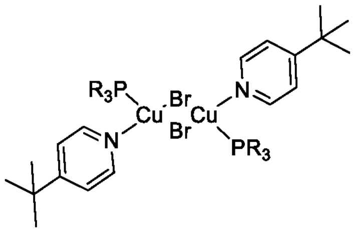

R = 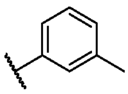

**E-Br-s**

| | Lösungsmittel | $V_{on}$ (1 cd $m^{-2}$) [V] | $\eta_{CE}{}^{a}$ [cd $A^{-1}$] | $\eta_{CE}{}^{a}$ [lm $W^{-1}$] | $B^{b}$ [cd $m^{-2}$] | $\lambda_{em}$(EL) [nm] | $\Phi_{EQE}{}^{a}$ |
|---|---|---|---|---|---|---|---|
| **E-Br-s** | Chlorbenzol | 3.7 | 5.8 | 3.0 | 1320 | 515 | 1.1% |
| **E-Br-s** | Toluol | 3.0 | 0.4 | 0.2 | 230 | 550 | - |

[a]= gemessen für 1 mA $cm^{-2}$; bei Toluol aufgrund der schlechten Effizienz nicht zuverlässig bestimmbar. [b]= gemessen bei 12 V Einsatzspannung.

**Beispiel 5** *Thermogravimetrie-Messungen*

Als Richtwert für eine thermische Mindeststabilität für die Verdampfungsprozessierung kann eine Zersetzungstemperatur Tdec von über 300 °C betrachtet werden. Diese wird meist über Thermogravimetrie unter einer Stickstoffatmosphäre (Normaldruck) als Temperatur, bis zu der 90 bzw. 95% der ursprünglichen Probenmasse vorhanden sind, definiert.
In den hier aufgeführten Experimenten wurde ein Standard-TGA-System der Firma Mettler-Toledo verwendet. Die Proben wurden unter einer Inertgasatmosphäre (Stickstoff) in Standard-TGA Tiegeln aus Aluminiumoxid vermessen, die Heizrate beträgt 10 K pro Minute. Die Messung wurde zwischen 300 K und 1000 K durchgeführt.

**Figuren**

Es zeigen:

**Figur 1A/B:** Exemplarische Darstellung des Aufbaus einer organischen lichtemittierenden Diode (OLED).

**Figur 2:** Thermogravimetrie-Scan (10 K $min^{-1}$, unter Stickstoff) des Komplexes 10-Br

**Figur 3:** HOMO (links) und LUMO (rechts) des Komplexes 10-Br

**Figur 4:** Energieniveau-Diagramm für das Bauteil ITO(130 nm)//PEDOT:PSS (30 nm)//Komplex (30 nm)//TSPO1 (15 nm)//TPBi (15 nm)//LiF(1 nm)//Al(100 nm).

**Figur 5:** L-I-V Kurve (links; durchgezogene Linie = Stromdichte; gestrichelte Linie = Leuchtdichte) für Komplex **10-Br.**

**Figur 6:** Elektrolumineszenzspektrum für Komplex **10-Br.**

## Patentansprüche

1. Zweikerniger Metallkomplex, aufweisend eine Struktur gemäß Formel A

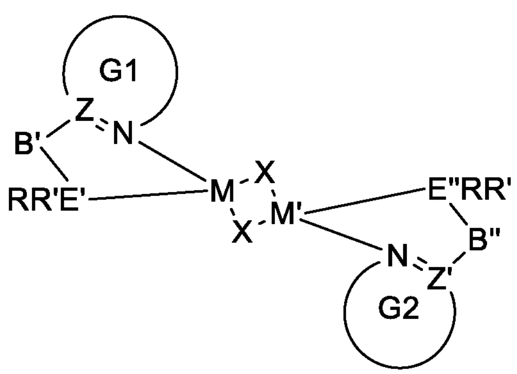

**Formel A**

wobei

M/M' = unabhängig ausgewählt aus der Gruppe bestehend aus Cu, Ag, Au;
X = unabhängig ausgewählt aus der Gruppe bestehend aus Cl, Br, I, Pseudohalogenide;
E'/E" = unabhängig ausgewählt aus der Gruppe bestehend aus P, As;
Z/Z' = unabhängig ausgewählt aus der Gruppe bestehend aus N oder C; wobei zwischen Z/Z' und N entweder eine Einfachbindung oder eine Doppelbindung vorhanden ist;
B'/B" = unabhängig voneinander Brücke mit mindestens 2 bis zu 17 Gliedern; die Glieder können bestehen aus $CH_2$, CHR'", CR'"R"", O, S, Se, NR'", PR'", AsR'", wobei R'" ein Rest ist ausgewählt aus der Gruppe bestehend aus Alkyl, Aryl, Hereroaryl, OR, SR, SeR, H und D;
G1/G2 = unabhängig voneinander fünf oder sechsgliedriges, heteroaromatisches Ringsystem, welches optional mit weiteren Resten wie R/R' substituiert oder mit weiteren aromatischen Ringen anneliert ist; einer der Reste an G1/G2 kann auch eine weitere Brücke sein, die eine Brücke wie B'/B" aufspannt; durch diese Brücke wird das Ringsystem G1 mit dem Donoratom E" und das Ringsystem G2 mit dem Donoratom E' verbunden;
jedes R und R' ist bei jedem Auftreten gleich oder verschieden H, Deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei optional eine oder mehrere nicht benachbarte $CH_2$-Gruppen durch $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sind und wobei optional ein oder mehrere H-Atome durch Deuterium, F, Cl, Br, I, CN, $CF_3$ oder $NO_2$ ersetzt sind, oder ein aromatisches oder heteroaromatisches Ringsystem mit 5 bis 60 aromatischen Ringatomen, das optional jeweils durch einen oder mehrere Reste $R^2$ substituiert ist, oder eine Aryloxy- oder Heteroaryloxygruppe mit 5 bis 60 aromatischen Ringatomen, die optional durch einen oder mehrere Reste $R^2$ substituiert ist, oder eine Diarylaminogruppe, Diheteroarylaminogruppe oder Arylheteroarylaminogruppe mit 10 bis 40 aromatischen Ringatomen, welche optional durch einen oder mehrere Reste $R^2$ substituiert ist, oder eine Kombination dieser Systeme; dabei bilden optional zwei oder mehrere dieser Substituenten R und R' auch miteinander ein mono- oder polycyclisches, aliphatisches, aromatisches und/oder benzoannelliertes Ringsystem;
$R^2$ bei jedem Auftreten gleich oder verschieden ist H, Deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die optional jeweils mit einem oder mehreren Resten $R^3$ substituiert ist, wobei optional eine oder mehrere nicht benachbarte $CH_2$-Gruppen durch $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ ersetzt sind und wobei optional ein oder mehrere H-Atome durch Deuterium, F, Cl, Br, I, CN, $CF_3$ oder $NO_2$ ersetzt sind, oder ein aromatisches oder heteroaromatisches Ringsystem mit 5 bis 60 aromatischen Ringatomen, das optional jeweils durch einen oder mehrere Reste $R^3$ substituiert ist, oder eine Aryloxy- oder Heteroaryloxygruppe mit 5 bis 60 aromatischen Ringatomen,

die optioanl durch einen oder mehrere Reste $R^3$ substituiert ist, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert ist, oder eine Kombination dieser Systeme; dabei bilden optional zwei oder mehrere dieser Substituenten $R^2$ auch miteinander ein mono- oder polycyclisches, aliphatisches, aromatisches und/oder benzoannelliertes Ringsystem;

$R^3$ bei jedem Auftreten gleich oder verschieden ist H, Deuterium, F, $CF_3$ oder ein aliphatischer, aromatischer und/oder heteroaromatischer Kohlenwasserstoffrest mit 1 bis 20 C-Atomen, in dem optional ein oder mehrere H-Atome durch F oder $CF_3$ ersetzt sind; dabei bilden optional zwei oder mehrere Substituenten $R^3$ miteinander ein mono- oder polycyclisches, aliphatisches Ringsystem.

2. Metallkomplex nach Anspruch 1, wobei G1/G2 unabhängig voneinander ausgewählt ist aus der Gruppe bestehend aus einer ungesättigten oder aromatischen N-heterozyklischen Einheit mit 5 oder 6 Ring-Atomen, die ausgewählt ist aus der Gruppe bestehend aus Pyridin, Pyridazin, Pyrimidin, Pyrazin, Triazin, Oxazol, Thiazol, Imidazol, Pyrazol, Isoxazol, Isothiazol, 1,2,3-Triazol, 1,2,4-Triazol, 1,2,4-Oxadiazol, 1,2,4-Thiadiazol, Tetrazol, 1,2,3,4-Oxatriazol, 1,2,3,4-Thiatriazol, die optional mit einem oder mehreren Resten R substituiert ist, wobei optional zwei oder mehr Reste R miteinander verknüpft sind und optional ein Ring oder Ringsystem bilden, insbesondere ein mono- oder polycyclisches, aliphatisches, aromatisches und/oder benzoannelliertes Ringsystem, wobei die Reste R zusammen mit dem zentralen 5- bis 6-Ring optional anellierte Ringsysteme ausbilden, wobei die Koordination an das M/M'-Atom über ein Stickstoffatom der N-heterozyklischen Einheit stattfindet:

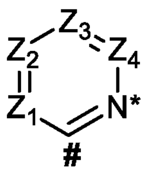 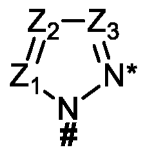 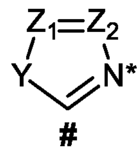 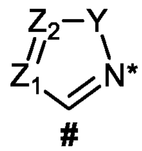 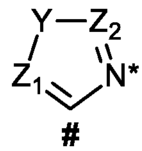

wobei

die Verknüpfung zu B' oder zu B" an der mit # gekennzeichneten Stelle stattfindet und * das Atom kennzeichnet, das die Komplexbindung eingeht;

$Z^1$-$Z^4$ = jeweils unabhängig voneinander ausgewählt aus der Gruppe bestehend aus dem Fragment CR und N, mit R ist bei jedem Auftreten gleich oder verschieden H, Deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die optional jeweils mit einem oder mehreren Resten $R^2$ substituiert ist, wobei optional eine oder mehrere nicht benachbarte $CH_2$-Gruppen durch $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sind und wobei optional ein oder mehrere H-Atome durch Deuterium, F, Cl, Br, I, CN, $CF_3$ oder $NO_2$ ersetzt sind, oder ein aromatisches oder heteroaromatisches Ringsystem mit 5 bis 60 aromatischen Ringatomen, das optional jeweils durch einen oder mehrere Reste $R^2$ substituiert ist, oder eine Aryloxy- oder Heteroaryloxygruppe mit 5 bis 60 aromatischen Ringatomen, die optional durch einen oder mehrere Reste $R^2$ substituiert ist, oder eine Diarylaminogruppe, Diheteroarylaminogruppe oder Arylheteroarylaminogruppe mit 10 bis 40 aromatischen Ringatomen, welche optional durch einen oder mehrere Reste $R^2$ substituiert ist, oder eine Kombination dieser Systeme;

$R^2$ bei jedem Auftreten gleich oder verschieden ist H, Deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die optional jeweils mit einem oder mehreren Resten $R^3$ substituiert sind, wobei optional eine oder mehrere nicht benachbarte $CH_2$-Gruppen durch $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ ersetzt sind und wobei optional ein oder mehrere H-Atome durch Deuterium, F, Cl, Br, I, CN, $CF_3$ oder $NO_2$ ersetzt sind, oder ein aromatisches oder heteroaromatisches Ringsystem mit 5 bis 60 aromatischen Ringatomen, das optional jeweils durch einen oder mehrere Reste $R^3$ substituiert ist, oder eine Aryloxy- oder Heteroaryloxygruppe mit 5 bis 60 aromatischen Ringatomen, die optional durch einen oder mehrere Reste $R^3$ substituiert ist, oder eine Diarylaminogruppe, Diheteroarylaminogruppe oder Arylheteroarylaminogruppe mit 10 bis 40 aromatischen Ringatomen, welche optional durch einen oder mehrere Reste $R^3$ substituiert ist, oder eine Kombination dieser Systeme; dabei bilden

optional zwei oder mehrere dieser Substituenten $R^2$ auch miteinander ein mono- oder polycyclisches, aliphatisches, aromatisches und/oder benzoannelliertes Ringsystem;
$R^3$ bei jedem Auftreten gleich oder verschieden ist H, Deuterium, F, $CF_3$ oder ein aliphatischer, aromatischer und/oder heteroaromatischer Kohlenwasserstoffrest mit 1 bis 20 C-Atomen, in dem optional ein oder mehrere H-Atome durch F oder $CF_3$ ersetzt sind; dabei bilden optional zwei oder mehrere Substituenten $R^3$ miteinander ein mono- oder polycyclisches, aliphatisches Ringsystem.

**3.** Metallkomplex nach Anspruch 1 oder 2, wobei die Brückenlänge der Brücke B'/B" 2 bis 4 substituierte oder unsubstituierte Einheiten aufweist, insbesondere aus 2 bis 4 substituierten oder unsubstituierten Einheiten besteht.

**4.** Metallkomplex nach Anspruch 1 bis 3, wobei

E'/E" = P,

M/M' = Cu und/oder
X = unabhängig ausgewählt aus der Gruppe bestehend aus Cl, Br, I, Pseudohalogenide.

**5.** Metallkomplex nach Anspruch 1 bis 4 mit folgender Struktur

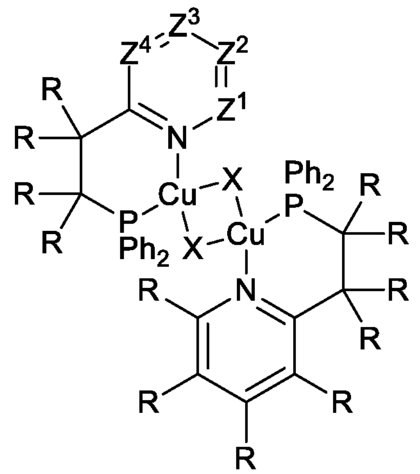

wobei die Gruppen und Reste wie in Anspruch 1 bis 3 definiert sind, wobei insbesondere $Z^1$ bis $Z^4$ gleich CR sind.

**6.** Metallkomplex nach Anspruch 1 bis 4 mit einer der folgenden Strukturen

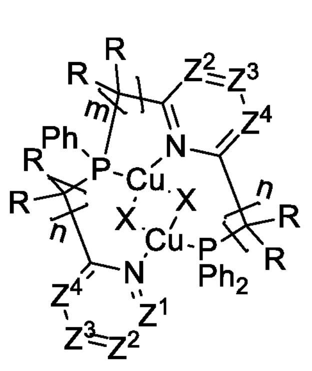

X = Cl, Br, I,
n = 2 - 4
m = 2 - 4

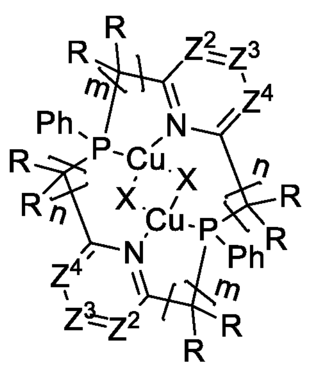

X = Cl, Br, I,
n = 2- 4
m = 2-4

wobei die angegebenen Gruppen und Reste wie in Anspruch 1 bis 3 definiert sind.

**7.** Verfahren zur Herstellung eines zweikernigen Metallkomplexes nach Anspruch 1 bis 6, aufweisend den Schritt der Substitution mindestens eines Liganden E’∩N und/oder E"∩N mit mindestens einer funktionellen Gruppe zur Verbesserung des Ladungsträgertransports, die ausgewählt ist aus der Gruppe bestehend aus Elektronenleiter und Lochleiter

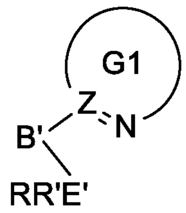

E’∩N

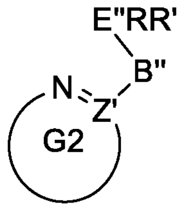

E”∩N

wobei die angegebenen Gruppen und Reste wie in Anspruch 1 bis 3 definiert sind.

**8.** Verwendung eines Metallkomplexes nach Anspruch 1 bis 6 als Emitter oder Absorber in einem Vakuumverdampfungsverfahren oder einem Verfahren aus einer Lösung zur Herstellung eines optoelektronischen Bauelements.

**9.** Verwendung nach Anspruch 8, wobei das optoelektronische Bauelement ausgewählt ist aus der Gruppe bestehend aus:

- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- Organischen Solarzellen,
- Organischen Feldeffekttransistoren,
- Organischen Lasern und
- Down-Konversions-Elementen.

**10.** Optoelektronisches Bauelement, aufweisend einen Metall(I)komplex nach Anspruch 1 bis 6.

**11.** Optoelektronisches Bauelement nach Anspruch 10, ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Licht-emittierender elektrochemischer Zelle, organischem Feldeffekttransistor und organischem Laser.

**12.** Optoelektronisches Bauelement nach Anspruch 10 oder 11, **dadurch gekennzeichnet, dass** der Metall(I)komplex als Emissionsmaterial in einer Emissionsschicht eingesetzt ist, wobei er entweder als Reinschicht oder in Kombination mit einem Matrixmaterial eingesetzt ist.

**13.** Optoelektronisches Bauelement nach Anspruch 12, insbesondere in Form einer organischen Elektrolumineszenzvorrichtung, **dadurch gekennzeichnet, dass** das Matrixmaterial ausgewählt ist aus der Gruppe bestehend aus Ketonen, Phosphinoxiden, Sulfoxiden, Sulfonen, Triarylaminen, Carbazolderivaten, Phenoxazinderivaten, Phenothiazinderivaten, Indolocarbazolderivaten, Azacarbazolen, bipolaren Matrixmaterialien, Silanen, Azaborolen, Boronestern, Triazinderivaten, Zinkkomplexen, Diazasilol- und Tetraazasilol-Derivaten, Benzophenonderivaten, Diphenylmethanderivate, Ultra-High-Energy-Gap-Matrixmatrialien und Mischungen aus zwei oder mehr der vorstehend genannten Matrixmaterialien.

**14.** Optoelektronisches Bauelement nach Anspruch 10 bis 13, aufweisend ein Substrat, eine Anode, eine Kathode und mindestens eine lichtemittierende Schicht, die einen Metallkomplex nach Anspruch 1 bis 6 und ein Hostmaterial aufweist, dessen Triplett (T1)- und Singulett (S1)-Energieniveaus energetisch höher liegen als die Triplett (T1)- und Singulett (S1)-Energieniveaus des Metallkomplexes nach Anspruch 1 bis 6, wobei die Anode und die Kathode auf das Substrat aufgebracht wird, und die lichtemittierende Schicht zwischen Anode und Kathode aufgebracht ist, wobei das optoelektronische Bauelement optional

- mindestens eine löcherinjizierende Schicht,
- mindestens eine elektroneninjizierende Schicht,
- mindestens eine löchertransportierende Schicht und
- mindestens eine elektronentransportierende Schicht aufweist,

wobei

- die löcherinjizierende Schicht zwischen der Anode und der löchertransportierenden Schicht
- die elektroneninjizierende Schicht zwischen der Kathode und der elektronentransportierenden Schicht und
- die lichtemittierende Schicht zwischen der löcher- und der elektronentransportierenden Schicht aufgebracht ist.

**15.** Verfahren zur Herstellung eines optoelektronischen Bauelements, wobei ein Metallkomplex nach Anspruch 1 bis 6 verwendet wird.

**16.** Verfahren nach Anspruch 15, **gekennzeichnet durch** das Aufbringen eines Metallkomplexes nach Anspruch 1 bis 6 auf einen Träger, wobei das Aufbringen insbesondere nass-chemisch, mittels kolloidaler Suspension oder mittels Sublimation erfolgt.

**17.** Verfahren nach Anspruch 15 oder 16 zur Herstellung eines optoelektronischen Bauelements in Form einer organischen Elektrolumineszenzvorrichtung, **dadurch gekennzeichnet, dass** mindestens eine Schicht mit einem Sublimationsverfahren beschichtet wird oder dass mindestens eine Schicht mit einem OVPD (Organic Vapour Phase Deposition) Verfahren oder mit Hilfe einer Trägergassublimation beschichtet wird oder dass mindestens eine Schicht aus Lösung oder mit einem beliebigen Druckverfahren hergestellt wird.

**18.** Verfahren zur Veränderung der Emissions- und/oder Absorptionseigenschaften eines elektronischen Bauelements, **gekennzeichnet durch** Einbringen eines Metall(I)komplexes nach Anspruch 1 bis 6 in ein Matrixmaterial zur Leitung von Elektronen oder Löchern in ein optoelektronisches Bauelement, insbesondere mittels Vakuumverdampfung.

**19.** Verwendung nach Anspruch 8, wobei es sich bei dem optoelektronischen Bauelement um ein Down-Konversions-Element zur Umwandlung von UV-Strahlung oder von blauem Licht in sichtbares Licht, insbesondere in grünes, gelbes oder rotes Licht (Down-Konversion) handelt.

**20.** Zusammensetzung, aufweisend einen Metallkomplex nach Anspruch 1 bis 6 und ein Hostmaterial, wobei die Triplett (T1)- und Singulett (S1)-Energieniveaus des Hostmaterials energetisch höher liegen als die Triplett (T1)- und Singulett (S1)-Energieniveaus des Metallkomplexes, und wobei der Metallkomplex Fluoreszenz oder thermisch aktivierte verzögerte Fluoreszenz zeigt, und einen $\Delta E$(S1-T1)-Wert zwischen dem untersten angeregten Singulett (S1)- und dem darunter liegenden Triplett (T1)-Zustand von kleiner als 2000 $cm^{-1}$ aufweist.

## Claims

**1.** Dinuclear metal complex having a structure according to formula A

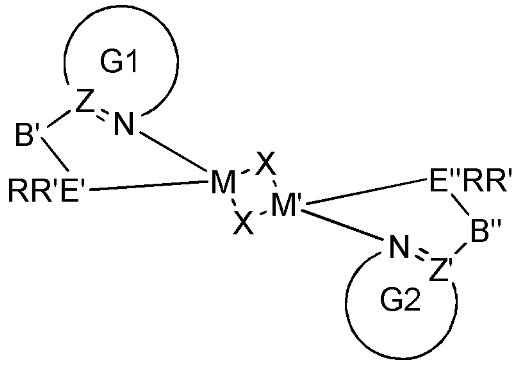

**Formula A**

wherein

M/M' = independently selected from the group consisting of Cu, Ag, Au;
X = independently selected from the group consisting of Cl, Br, I, pseudohalides;
E'/E" = independently selected from the group consisting of P, As;
Z/Z' = independently selected from the group consisting of N and C; wherein either a single bond or a double bond is present between Z/Z' and N;
B'/B" = independently a bridge having at least 2 up to 17 members; the members may consist of $CH_2$, CHR''', CR'''R'''', O, S, Se, NR''', PR''', AsR''', wherein R''' is a moiety selected from the group consisting of alkyl, aryl, heteroaryl, OR, SR, SeR, H and D;
G1/G2 = independently five- or six-membered, heteroaromatic ring system optionally substituted by further moieties such as R/R' or fused to further aromatic rings; one of the moieties on G1/G2 may also be a further bridge which forms a bridge like B'/B"; this bridge connects the ring system G1 to the donor atom E" and the ring system G2 to the donor atom E';
each R and R' is the same or different at each instance and is H, deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which may be substituted by one or more $R^2$ moieties, wherein one or more nonadjacent $CH_2$ groups are optionally replaced by $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S or $CONR^2$ and wherein one or more hydrogen atoms are optionally replaced by deuterium, F, Cl, Br, I, CN, $CF_3$ or $NO_2$, or an aromatic or heteroaromatic ring system which has 5 to 60 aromatic ring atoms and is optionally substituted in each case by one or more $R^2$ moieties, or an aryloxy or heteroaryloxy group which has 5 to 60 aromatic ring atoms and is optionally substituted by one or more $R^2$ moieties, or a diarylamino group, diheteroarylamino group or arylheteroarylamino group which has 10 to 40 aromatic ring atoms and is optionally substituted by one or more $R^2$ moieties, or a combination of these systems; at the same time, two or more of these R and R' substituents together optionally also form a mono- or polycyclic, aliphatic, aromatic and/or benzofused ring system;
$R^2$ is the same or different at each instance and is H, deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which is optionally substituted by one or more $R^3$ moieties, wherein one or more nonadjacent $CH_2$ groups are optionally replaced by $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$ and wherein one or more hydrogen atoms are optionally replaced by deuterium, F, Cl, Br, I, CN, $CF_3$ or $NO_2$, or an aromatic or heteroaromatic ring system which has 5 to 60 aromatic ring atoms and is optionally substituted in each case by one or more $R^3$ moieties, or an aryloxy or heteroaryloxy group which has 5 to 60 aromatic ring atoms and is optionally substituted by one or more $R^3$ moieties, or a diarylamino group, diheteroarylamino group or arylheteroarylamino group which has 10 to 40 aromatic ring atoms and is substituted by one or more $R^3$ moieties, or a combination of these systems; at the same time, two or more of these $R^2$ substituents together optionally also form a mono- or polycyclic, aliphatic, aromatic and/or benzofused ring system;
$R^3$ is the same or different at each instance and is H, deuterium, F, $CF_3$ or an aliphatic, aromatic and/or heteroaromatic hydrocarbyl moiety having 1 to 20 carbon atoms, in which one or more hydrogen atoms have optionally been replaced by F or $CF_3$ ; at the same time, two or more $R^3$ substituents together optionally form a mono- or polycyclic, aliphatic ring system.

2. Metal complex according to Claim 1, wherein G1/G2 is independently selected from the group consisting of an unsaturated or aromatic N-heterocyclic unit having 5 or 6 ring atoms, selected from the group consisting of pyridine, pyridazine, pyrimidine, pyrazine, triazine, oxazole, thiazole, imidazole, pyrazole, isoxazole, isothiazole, 1,2,3-triazole, 1,2,4-triazole, 1,2,4-oxadiazole, 1,2,4-thiadiazole, tetrazole, 1,2,3,4-oxatriazole, 1,2,3,4-thiatriazole, which are each optionally substituted by one or more R moieties, wherein two or more R moieties are optionally joined to one another and optionally form a ring or ring system, especially a mono- or polycyclic, aliphatic, aromatic and/or benzofused ring system, wherein the R moieties together with the central 5- or 6-membered ring optionally form fused ring systems, wherein the coordination to the M/M' atom takes place via a nitrogen atom in the N-heterocyclic unit:

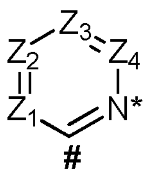 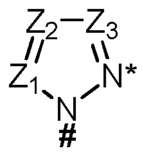 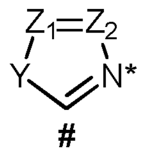 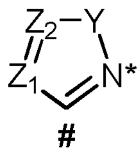 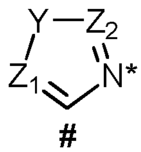

wherein the bond to B' or to B" takes place at the site indicated by # and * indicates the atom which enters into the complex bond;

$Z^1$-$Z^4$ = each independently selected from the group consisting of the fragment CR and N, with R being the same or different at each instance and being H, deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which is optionally substituted by one or more $R^2$ moieties, wherein one or more nonadjacent $CH_2$ groups are optionally replaced by $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S or $CONR^2$ and wherein one or more hydrogen atoms are optionally replaced by deuterium, F, Cl, Br, I, CN, $CF_3$ or $NO_2$, or an aromatic or heteroaromatic ring system which has 5 to 60 aromatic ring atoms and is optionally substituted in each case by one or more $R^2$ moieties, or an aryloxy or heteroaryloxy group which has 5 to 60 aromatic ring atoms and is optionally substituted by one or more $R^2$ moieties, or a diarylamino group, diheteroarylamino group or arylheteroarylamino group which has 10 to 40 aromatic ring atoms and is optionally substituted by one or more $R^2$ moieties, or a combination of these systems;

$R^2$ is the same or different at each instance and is H, deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, a linear alkyl, alkoxy or thioalkoxy group having 1 to 40 carbon atoms or a linear alkenyl or alkynyl group having 2 to 40 carbon atoms or a branched or cyclic alkyl, alkenyl, alkynyl, alkoxy or thioalkoxy group having 3 to 40 carbon atoms, each of which is optionally substituted by one or more $R^3$ moieties, wherein one or more nonadjacent $CH_2$ groups are optionally replaced by $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S or $CONR^3$ and wherein one or more hydrogen atoms are optionally replaced by deuterium, F, Cl, Br, I, CN, $CF_3$ or $NO_2$, or an aromatic or heteroaromatic ring system which has 5 to 60 aromatic ring atoms and is optionally substituted in each case by one or more $R^3$ moieties, or an aryloxy or heteroaryloxy group which has 5 to 60 aromatic ring atoms and is optionally substituted by one or more $R^3$ moieties, or a diarylamino group, diheteroarylamino group or arylheteroarylamino group which has 10 to 40 aromatic ring atoms and is optionally substituted by one or more $R^3$ moieties, or a combination of these systems; at the same time, two or more of these $R^2$ substituents together optionally also form a mono- or polycyclic, aliphatic, aromatic and/or benzofused ring system;

$R^3$ is the same or different at each instance and is H, deuterium, F, $CF_3$ or an aliphatic, aromatic and/or heteroaromatic hydrocarbyl moiety having 1 to 20 carbon atoms, in which one or more hydrogen atoms have optionally been replaced by F or $CF_3$; at the same time, two or more $R^3$ substituents together optionally form a mono- or polycyclic, aliphatic ring system.

3. Metal complex according to Claim 1 or 2, wherein the bridge length of the bridge B'/B" has 2 to 4 substituted or unsubstituted units, and especially consists of 2 to 4 substituted or unsubstituted units.

4. Metal complex according to Claims 1 to 3, wherein

E'/E" = P,

M/M' = Cu and/or
X = independently selected from the group consisting of Cl, Br, I, pseudohalides.

**5.** Metal complex according to Claims 1 to 4, having the following structure:

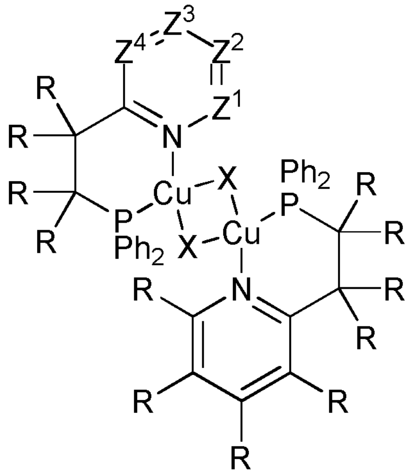

wherein the groups and moieties are as defined in Claims 1 to 3, especially wherein $Z^1$ to $Z^4$ are CR.

**6.** Metal complex according to Claims 1 to 4, having one of the following structures:

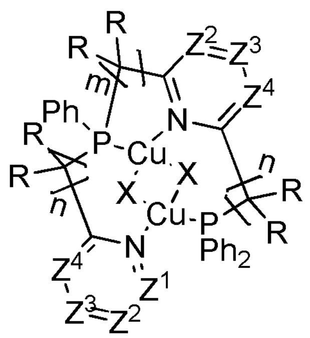

X = Cl, Br, I,
n = 2 - 4
m = 2 - 4

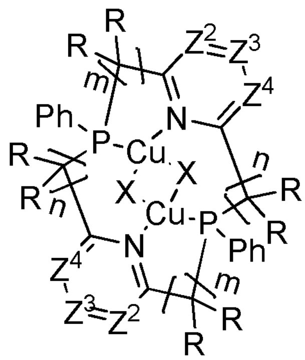

X = Cl, Br, I,
n = 2- 4
m = 2-4

wherein the groups and moieties specified are as defined in Claims 1 to 3.

**7.** Process for preparing a dinuclear metal complex according to Claims 1 to 6, including the step of substituting at least one E'∩N and/or E"∩N ligand with at least one functional group for improving charge carrier transport, selected from the group consisting of electron conductors and hole conductors

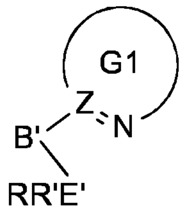

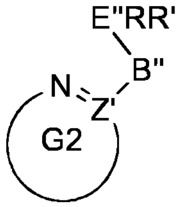

E'∩N E''∩N

wherein the groups and moieties specified are as defined in Claims 1 to 3.

**8.** Use of a metal complex according to Claims 1 to 6 as emitter or absorber in a vacuum vaporization process or a process from a solution for producing an optoelectronic component.

**9.** Use according to Claim 8, wherein the optoelectronic component is selected from the group consisting of:

- organic light-emitting components (OLEDs),
- light-emitting electrochemical cells,
- OLED sensors, especially in gas and vapour sensors not hermetically shielded from the outside,
- organic solar cells,
- organic field-effect transistors,
- organic lasers and
- down-conversion elements.

**10.** Optoelectronic component including a metal(I) complex according to Claims 1 to 6.

**11.** Optoelectronic component according to Claim 10, in the form of a component selected from the group consisting of organic light-emitting component, organic diode, organic solar cell, organic transistor, organic light-emitting diode, light-emitting electrochemical cell, organic field-effect transistor and organic laser.

**12.** Optoelectronic component according to Claim 10 or 11, **characterized in that** the metal(I) complex is used as emission material in an emission layer, and is used either as a pure layer or in combination with a matrix material.

**13.** Optoelectronic component according to Claim 12, especially in the form of an organic electroluminescent device, **characterized in that** the matrix material is selected from the group consisting of ketones, phosphine oxides, sulphoxides, sulphones, triarylamines, carbazole derivatives, phenoxazine derivatives, phenothiazine derivatives, indolocarbazole derivatives, azacarbazoles, bipolar matrix materials, silanes, azaboroles, boronic esters, triazine derivatives, zinc complexes, diazasilole and tetraazasilole derivatives, benzophenone derivatives, diphenylmethane derivatives, ultra-high energy gap matrix materials and mixtures of two or more of the aforementioned matrix materials.

**14.** Optoelectronic component according to Claims 10 to 13, including a substrate, an anode, a cathode and at least one light-emitting layer including a metal complex according to Claims 1 to 6 and a host material having triplet (T1) and singlet (S1) energy levels at higher energy than the triplet (T1) and singlet (S1) energy levels of the metal complex according to Claims 1 to 6, wherein the anode and the cathode have been applied to the substrate, and the light-emitting layer has been applied between the anode and cathode, wherein the optoelectronic component optionally includes

- at least one hole-injecting layer,
- at least one electron-injecting layer,
- at least one hole-transporting layer and
- at least one electron-transporting layer,

wherein

- the hole-injecting layer has been applied between the anode and the hole-transporting layer,
- the electron-injecting layer has been applied between the cathode and the electron-transporting layer and
- the light-emitting layer has been applied between the hole-transporting and electron-transporting layers.

**15.** Process for producing an optoelectronic component, wherein a metal complex according to Claims 1 to 6 is used.

**16.** Process according to Claim 15, **characterized by** the application of a metal complex according to Claims 1 to 6 to a carrier, wherein the application is especially effected by wet-chemical means, by means of colloidal suspension or by means of sublimation.

**17.** Process according to Claim 15 or 16 for production of an optoelectronic component in the form of an organic electroluminescent device, **characterized in that** at least one layer is applied by a sublimation process or **in that** at least one layer is applied by an OVPD (organic vapour phase deposition) process or with the aid of a carrier gas sublimation or **in that** at least one layer is produced from solution or by any desired printing process.

**18.** Process for altering the emission and/or absorption properties of an electronic component, **characterized by** introduction of a metal(I) complex according to Claims 1 to 6 into a matrix material for conduction of electrons or holes into an optoelectronic component, especially by means of vacuum evaporation.

**19.** Use according to Claim 8, wherein the optoelectronic component is a down-conversion element for conversion of UV radiation or of blue light to visible light, especially to green, yellow or red light (down-conversion).

**20.** Composition including a metal complex according to Claims 1 to 6 and a host material, wherein the triplet (T1) and singlet (S1) energy levels of the host material are at higher energy than the triplet (T1) and singlet (S1) energy levels of the metal complex, and wherein the metal complex exhibits fluorescence or thermally activated retarded fluorescence, and has a $\Delta E(S1-T1)$ value between the lowermost excited singlet state (S1) and the triplet state (T1) beneath of less than 2000 $cm^{-1}$.

**Revendications**

**1.** Complexe métallique binucléaire, comprenant une structure selon la formule A

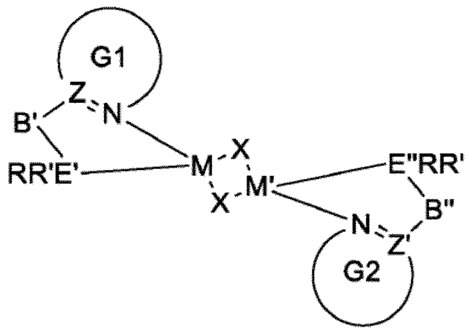

Formule A

dans laquelle

M/M' = choisis indépendamment dans le groupe constitué par Cu, Ag, Au ;
X = choisis indépendamment dans le groupe constitué par Cl, Br, I, pseudohalogénures ;
E'/E" = choisis indépendamment dans le groupe constitué par P, As ;
Z/Z' = choisis indépendamment dans le groupe constitué par N ou C ; une simple liaison ou une double liaison étant présente entre Z/Z' et N ;
B'/B" = indépendamment l'un de l'autre, pont contenant au moins 2 à 17 chaînons ; les chaînons pouvant être

constitués par $CH_2$, CHR''', CR'''R'''', O, S, Se, NR''', PR''', AsR''', R''' étant un radical choisi dans le groupe constitué par alkyle, aryle, hétéroaryle, OR, SR, SeR, H et D ;
G1/G2 = indépendamment l'un de l'autre, système cyclique hétéroaromatique à cinq ou six chaînons, qui est éventuellement substitué avec d'autres radicaux tels que R/R' ou annelé avec d'autres cycles aromatiques ; un des radicaux sur G1/G2 pouvant également être un autre pont, qui comprend un pont tel que B'/B" ; ce pont reliant le système cyclique G1 avec l'atome donneur E" et le système cyclique G2 avec l'atome donneur E' ;
chaque R et R' étant à chaque occurrence, de manière identique ou différente, H, deutérium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, un groupe alkyle, alcoxy ou thioalcoxy linéaire de 1 à 40 atomes C ou un groupe alcényle ou alcynyle linéaire de 2 à 40 atomes C, ou un groupe alkyle, alcényle, alcynyle, alcoxy ou thioalcoxy ramifié ou cyclique de 3 à 40 atomes C, qui peut à chaque fois être substitué avec un ou plusieurs radicaux $R^2$, un ou plusieurs groupes $CH_2$ non voisins étant éventuellement remplacés par $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S ou $CONR^2$, et un ou plusieurs atomes H étant éventuellement remplacés par deutérium, F, Cl, Br, I, CN, $CF_3$ ou $NO_2$, ou un système cyclique aromatique ou hétéroaromatique de 5 à 60 atomes de cycle aromatique, qui est éventuellement substitué par un ou plusieurs radicaux $R^2$, ou un groupe aryloxy ou hétéroaryloxy de 5 à 60 atomes de cycle aromatique, qui est éventuellement substitué par un ou plusieurs radicaux $R^2$, ou un groupe diarylamino, un groupe dihétéroarylamino ou un groupe arylhétéroarylamino de 10 à 40 atomes de cycle aromatique, qui est éventuellement substitué par un ou plusieurs radicaux $R^2$, ou une combinaison de ces systèmes ; deux ou plusieurs de ces substituants R et R' formant éventuellement également les uns avec les autres un système cyclique mono- ou polycyclique, aliphatique, aromatique et/ou benzoannelé ;
$R^2$ étant à chaque occurrence, de manière identique ou différente, H, deutérium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, un groupe alkyle, alcoxy ou thioalcoxy linéaire de 1 à 40 atomes C, ou un groupe alcényle ou alcynyle linéaire de 2 à 40 atomes C, ou un groupe alkyle, alcényle, alcynyle, alcoxy ou thioalcoxy ramifié ou cyclique de 3 à 40 atomes C, qui est à chaque fois éventuellement substitué avec un ou plusieurs radicaux $R^3$, un ou plusieurs groupes $CH_2$ non voisins étant éventuellement remplacés par $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S ou $CONR^3$, et un ou plusieurs atomes H étant éventuellement remplacés par deutérium, F, Cl, Br, I, CN, $CF_3$ ou $NO_2$, ou un système cyclique aromatique ou hétéroaromatique de 5 à 60 atomes de cycle aromatique, qui est éventuellement substitué par un ou plusieurs radicaux $R^3$, ou un groupe aryloxy ou hétéroaryloxy de 5 à 60 atomes de cycle aromatique, qui est éventuellement substitué par un ou plusieurs radicaux $R^3$, ou un groupe diarylamino, un groupe dihétéroarylamino ou un groupe arylhétéroarylamino de 10 à 40 atomes de cycle aromatique, qui est éventuellement substitué par un ou plusieurs radicaux $R^3$, ou une combinaison de ces systèmes ; deux ou plusieurs de ces substituants $R^2$ formant éventuellement également les uns avec les autres un système cyclique mono- ou polycyclique, aliphatique, aromatique et/ou benzoannelé ;
$R^3$ étant à chaque occurrence, de manière identique ou différente, H, deutérium, F, $CF_3$ ou un radical hydrocarboné aliphatique, aromatique et/ou hétéroaromatique de 1 à 20 atomes C, dans lequel un ou plusieurs atomes H sont éventuellement remplacés par F ou $CF_3$ ; deux ou plusieurs substituants $R^3$ formant éventuellement les uns avec les autres un système cyclique mono- ou polycyclique, aliphatique.

**2.** Complexe métallique selon la revendication 1, dans lequel G1/G2 sont choisis indépendamment l'un de l'autre dans le groupe constitué par une unité N-hétérocyclique insaturée ou aromatique à 5 ou 6 atomes de cycle, qui est choisie dans le groupe constitué par pyridine, pyridazine, pyrimidine, pyrazine, triazine, oxazole, thiazole, imidazole, pyrazole, isoxazole, isothiazole, 1,2,3-triazole, 1,2,4-triazole, 1,2,4-oxadiazole, 1,2,4-thiadiazole, tétrazole, 1,2,3,4-oxatriazole, 1,2,3,4-thiatriazole, qui est éventuellement substitué avec un ou plusieurs radicaux R, deux radicaux R ou plus étant éventuellement reliés les uns avec les autres et formant éventuellement un cycle ou un système cyclique, notamment un système cyclique mono- ou polycyclique, aliphatique, aromatique et/ou benzoannelé, les radicaux R formant éventuellement ensemble avec le cycle à 5 ou 6 central des systèmes cycliques annelés, la coordination sur l'atome M/M' ayant lieu par un atome d'azote de l'unité N-hétérocyclique :

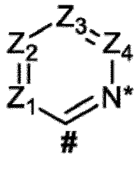 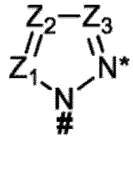 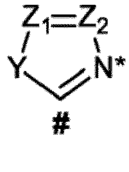 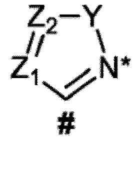 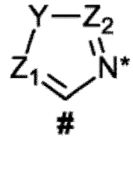

la liaison à B' ou B" ayant lieu à l'emplacement **caractérisé par** #, et * désignant l'atome qui réalise la complexation ;

$Z^1$ à $Z^4$ = choisis chacun indépendamment les uns des autres dans le groupe constitué par le fragment CR et N, les R étant à chaque occurrence, de manière identique ou différente, H, deutérium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, un groupe alkyle, alcoxy ou thioalcoxy linéaire de 1 à 40 atomes C, ou un groupe alcényle ou alcynyle linéaire de 2 à 40 atomes C, ou un groupe alkyle, alcényle, alcynyle, alcoxy ou thioalcoxy ramifié ou cyclique de 3 à 40 atomes C, qui est à chaque fois éventuellement substitué par un ou plusieurs radicaux $R^2$, un ou plusieurs groupes $CH_2$ non voisins étant éventuellement remplacés par $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S ou $CONR^2$, et un ou plusieurs atomes H étant éventuellement remplacés par deutérium, F, Cl, Br, I, CN, $CF_3$ ou $NO_2$, ou un système cyclique aromatique ou hétéroaromatique de 5 à 60 atomes de cycle aromatique, qui est éventuellement substitué par un ou plusieurs radicaux $R^2$, ou un groupe aryloxy ou hétéroaryloxy de 5 à 60 atomes de cycle aromatique, qui est éventuellement substitué par un ou plusieurs radicaux $R^2$, ou un groupe diarylamino, un groupe dihétéroarylamino ou un groupe arylhétéroarylamino de 10 à 40 atomes de cycle aromatique, qui est éventuellement substitué par un ou plusieurs radicaux $R^2$, ou une combinaison de ces systèmes ;

$R^2$ étant à chaque occurrence, de manière identique ou différente, H, deutérium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, un groupe alkyle, alcoxy ou thioalcoxy linéaire de 1 à 40 atomes C, ou un groupe alcényle ou alcynyle linéaire de 2 à 40 atomes C, ou un groupe alkyle, alcényle, alcynyle, alcoxy ou thioalcoxy ramifié ou cyclique de 3 à 40 atomes C, qui est à chaque fois éventuellement substitué avec un ou plusieurs radicaux $R^3$, un ou plusieurs groupes $CH_2$ non voisins étant éventuellement remplacés par $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S ou $CONR^3$, et un ou plusieurs atomes H étant éventuellement remplacés par deutérium, F, Cl, Br, I, CN, $CF_3$ ou $NO_2$, ou un système cyclique aromatique ou hétéroaromatique de 5 à 60 atomes de cycle aromatique, qui est à chaque fois éventuellement substitué par un ou plusieurs radicaux $R^3$, ou un groupe aryloxy ou hétéroaryloxy de 5 à 60 atomes de cycle aromatique, qui est éventuellement substitué par un ou plusieurs radicaux $R^3$, ou un groupe diarylamino, un groupe dihétéroarylamino ou un groupe arylhétéroarylamino de 10 à 40 atomes de cycle aromatique, qui est éventuellement substitué par un ou plusieurs radicaux $R^3$, ou une combinaison de ces systèmes ; deux ou plusieurs de ces substituants $R^2$ formant éventuellement également les uns avec les autres un système cyclique mono- ou polycyclique, aliphatique, aromatique et/ou benzoannelé ;

$R^3$ étant à chaque occurrence, de manière identique ou différente, H, deutérium, F, $CF_3$ ou un radical hydrocarboné aliphatique, aromatique et/ou hétéroaromatique de 1 à 20 atomes C, dans lequel un ou plusieurs atomes H sont éventuellement remplacés par F ou $CF_3$ ; deux substituants $R^3$ ou plus formant éventuellement les uns avec les autres un système cyclique mono- ou polycyclique, aliphatique.

**3.** Complexe métallique selon la revendication 1 ou 2, dans lequel la longueur de pont des ponts B'/B" comprend 2 à 4 unités substituées ou non substituées, notamment 2 à 4 unités substituées ou non substituées.

**4.** Complexe métallique selon les revendications 1 à 3, dans lequel

$$E'/E'' = P,$$

M/M' = Cu et/ou

X = choisis indépendamment dans le groupe constitué par Cl, Br, I, pseudohalogénures.

**5.** Complexe métallique selon les revendications 1 à 4, ayant la structure suivante :

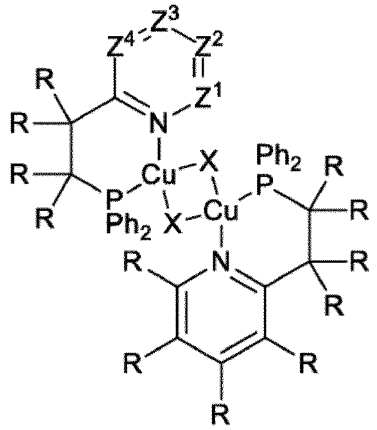

dans laquelle les groupes et les radicaux sont tels que définis dans les revendications 1 à 3, $Z^1$ à $Z^4$ représentant notamment CR.

**6.** Complexe métallique selon les revendications 1 à 4, présentant une des structures suivantes :

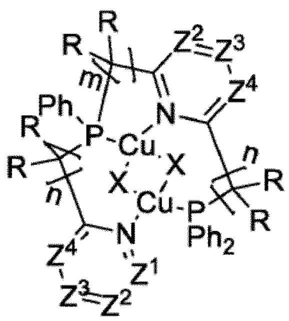

X = Cl, Br, I,
n = 2 - 4
m = 2 - 4

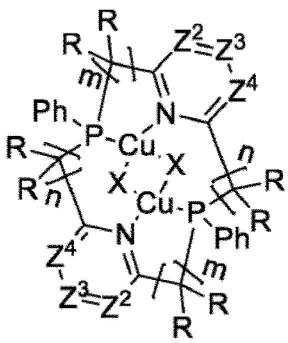

X = Cl, Br, I,
n = 2- 4
m = 2-4

dans lesquelles les groupes et les radicaux indiqués sont tels que définis dans les revendications 1 à 3.

**7.** Procédé de fabrication d'un complexe métallique binucléaire selon les revendications 1 à 6, comprenant l'étape de substitution d'au moins un ligand E'∩N et/ou E"∩N avec au moins un groupe fonctionnel pour améliorer le transport des porteurs de charges, qui est choisi dans le groupe constitué par les conducteurs d'électrons et les conducteurs de trous

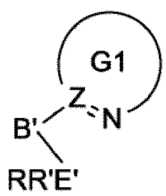

E'∩N

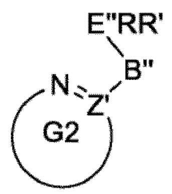

E"∩N

dans lesquelles les groupes et les radicaux indiqués sont tels que définis dans les revendications 1 à 3.

**8.** Utilisation d'un complexe métallique selon les revendications 1 à 6 en tant qu'émetteur ou absorbeur dans un procédé d'évaporation sous vide ou dans un procédé à partir d'une solution pour la fabrication d'un composant optoélectronique.

**9.** Utilisation selon la revendication 8, dans laquelle le composant optoélectronique est choisi dans le groupe constitué par :

- les composants organiques à émission de lumière (OLEDs),
- les cellules électrochimiques à émission de lumière,
- les capteurs OLED, notamment dans des capteurs de gaz et de vapeur non blindés hermétiquement vers l'extérieur,
- les cellules solaires organiques,
- les transistors à effet de champ organiques,
- les lasers organiques et
- les éléments de descente en fréquence.

**10.** Composant optoélectronique, comprenant un complexe de métal (I) selon les revendications 1 à 6.

**11.** Composant optoélectronique selon la revendication 10, conçu sous la forme d'un composant choisi dans le groupe constitué par un composant organique à émission de lumière, une diode organique, une cellule solaire organique, un transistor organique, une diode organique à émission de lumière, une cellule électrochimique à émission de lumière, un transistor à effet de champ organique et un laser organique.

**12.** Composant optoélectronique selon la revendication 10 ou 11, **caractérisé en ce que** le complexe de métal (I) est utilisé en tant que matériau d'émission dans une couche d'émission, celui-ci étant utilisé sous la forme d'une couche pure ou en combinaison avec un matériau de matrice.

**13.** Composant optoélectronique selon la revendication 12, notamment sous la forme d'un dispositif électroluminescent organique, **caractérisé en ce que** le matériau de matrice est choisi dans le groupe constitué par les cétones, les oxydes de phosphine, les sulfoxydes, les sulfones, les triarylamines, les dérivés de carbazole, les dérivés de phénoxazine, les dérivés de phénothiazine, les dérivés d'indolocarbazole, les azacarbazoles, les matériaux de matrice bipolaires, les silanes, les azaboroles, les esters de bore, les dérivés de triazine, les complexes de zinc, les dérivés de diazasilol et de tétraazasilol, les dérivés de benzophénone, les dérivés de diphénylméthane, les matériaux de matrice à écart énergétique ultra-élevé et les mélanges de deux ou plus des matériaux de matrice susmentionnés.

**14.** Composant optoélectronique selon les revendications 10 à 13, comprenant un substrat, une anode, une cathode et au moins une couche à émission de lumière, qui comprend un complexe métallique selon les revendications 1 à 6 et un matériau hôte, dont les niveaux d'énergie triplet (T1) et singulet (S1) sont énergétiquement plus élevés que les niveaux d'énergie triplet (T1) et singulet (S1) du complexe métallique selon les revendications 1 à 6, l'anode et la cathode étant appliquées sur le substrat, et la couche à émission de lumière étant appliquée entre l'anode et la cathode, le composant optoélectronique comprenant éventuellement

- au moins une couche d'injection de trous,
- au moins une couche d'injection d'électrons,
- au moins une couche de transport de trous et
- au moins une couche de transport d'électrons,
- la couche d'injection de trous étant appliquée entre l'anode et la couche de transport de trous,
- la couche d'injection d'électrons étant appliquée entre la cathode et la couche de transport d'électrons, et
- la couche à émission de lumière étant appliquée entre la couche de transport de trous et la couche de transport d'électrons.

**15.** Procédé de fabrication d'un composant optoélectronique, dans lequel un complexe métallique selon les revendications 1 à 6 est utilisé.

**16.** Procédé selon la revendication 15, **caractérisé par** l'application d'un complexe métallique selon les revendications 1 à 6 sur un support, l'application ayant notamment lieu par voie chimique humide, au moyen d'une suspension

colloïdale ou par sublimation.

**17.** Procédé selon la revendication 15 ou 16 pour la fabrication d'un composant optoélectronique sous la forme d'un dispositif électroluminescent organique, **caractérisé en ce qu'**au moins une couche est revêtue par un procédé de sublimation ou **en ce qu'**au moins une couche est revêtue par un procédé OVPD (Organic Vapour Phase Déposition) ou à l'aide d'une sublimation de gaz vecteur, ou **en ce qu'**au moins une couche est fabriquée à partir d'une solution ou par un procédé d'impression quelconque.

**18.** Procédé de modification des propriétés d'émission et/ou d'absorption d'un composant électronique, **caractérisé par** l'introduction d'un complexe de métal (I) selon les revendications 1 à 6 dans un matériau de matrice pour la conduction d'électrons ou de trous dans un composant optoélectronique, notamment par évaporation sous vide.

**19.** Utilisation selon la revendication 8, dans laquelle le composant optoélectronique est un élément de descente en fréquence pour la conversion d'un rayonnement UV ou d'une lumière bleue en lumière visible, notamment en lumière verte, jaune ou rouge (descente en fréquence).

**20.** Composition, comprenant un complexe métallique selon les revendications 1 à 6 et un matériau hôte, les niveaux d'énergie triplet (T1) et singulet (S1) du matériau hôte étant énergétiquement plus élevés que les niveaux d'énergie triplet (T1) et singulet (S1) du complexe métallique, et le complexe métallique présentant une fluorescence ou une fluorescence retardée activée thermiquement, et présentant une valeur $\Delta E(S1\text{-}T1)$ entre l'état singulet excité le plus bas (S1) et l'état triplet sous-jacent (T1) de moins de 2 000 $cm^{-1}$.

Figur 1A

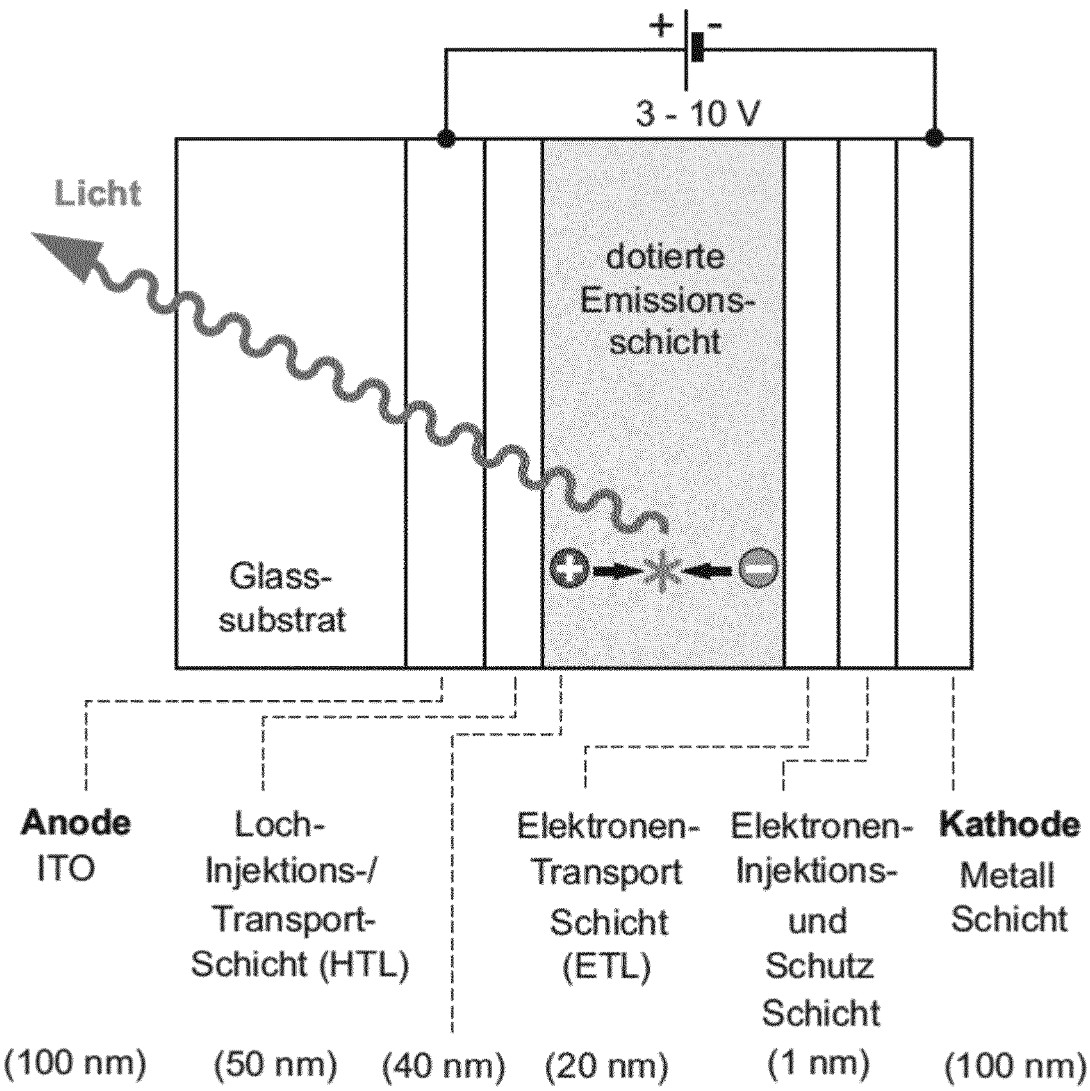
+
-
3 - 10 V
Licht
dotierte Emissions- schicht
Glass- substrat
Anode ITO
Loch- Injektions-/ Transport- Schicht (HTL)
Elektronen- Transport Schicht (ETL)
Elektronen- Injektions- und Schutz Schicht
Kathode Metall Schicht
(100 nm)
(50 nm)
(40 nm)
(20 nm)
(1 nm)
(100 nm)

**Figur 1B**

| |
|---|
| Kathode |
| Elektroneninjektionsschicht EIL |
| Lochblockierschicht HBL / Elektronenleitschicht ETL |
| Dotierte Emitterschicht EML |
| Lochtransportschicht HTL / Elektronenblockierschicht EBL |
| Lochinjektionsschicht HIL |
| Anode |
| Trägermaterial Glas |

Figur 2

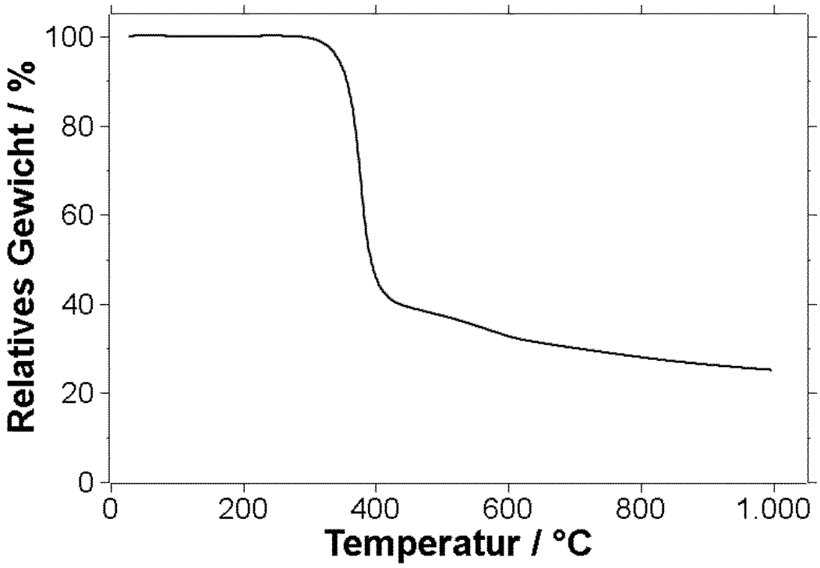


Figur 3

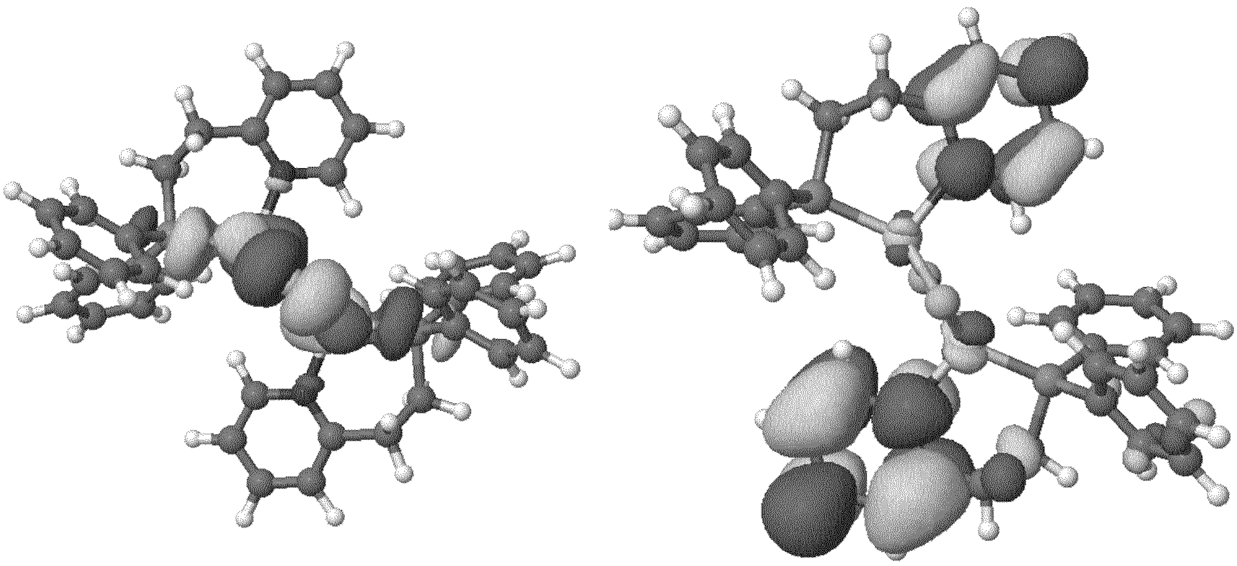

Figur 4

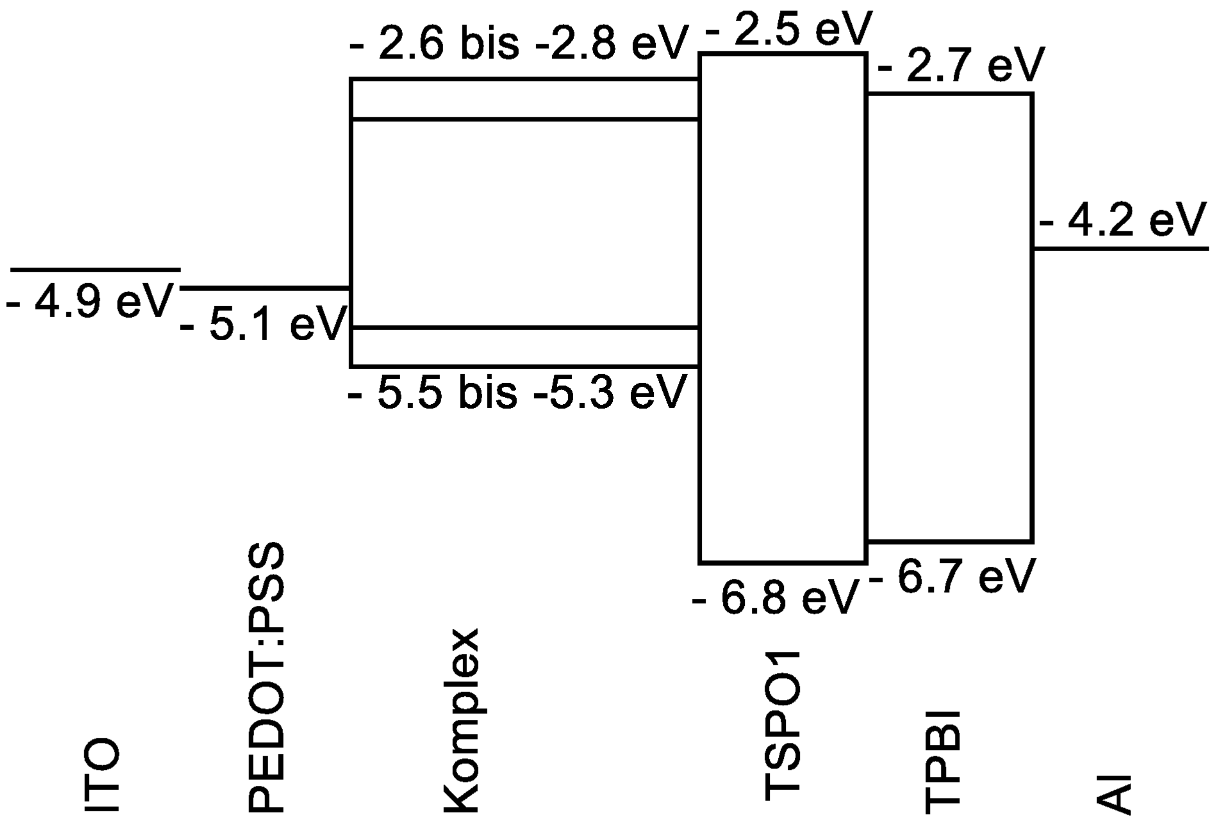
- 2.6 bis -2.8 eV
- 2.5 eV
- 2.7 eV
- 4.2 eV
- 4.9 eV
- 5.1 eV
- 5.5 bis -5.3 eV
- 6.8 eV
- 6.7 eV
ITO
PEDOT:PSS
Komplex
TSPO1
TPBI
Al

Figur 5

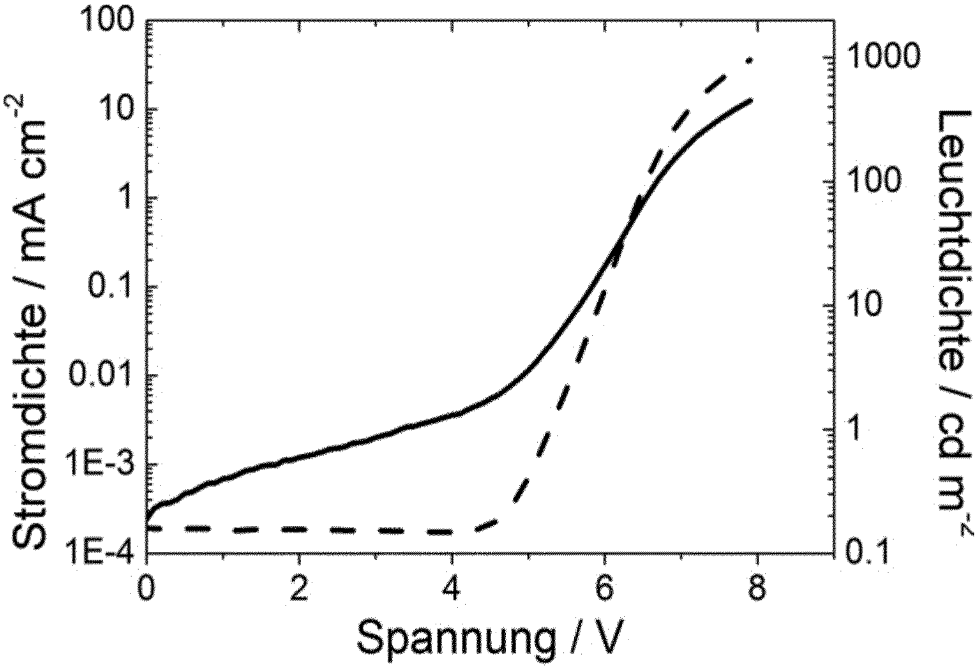


Figur 6

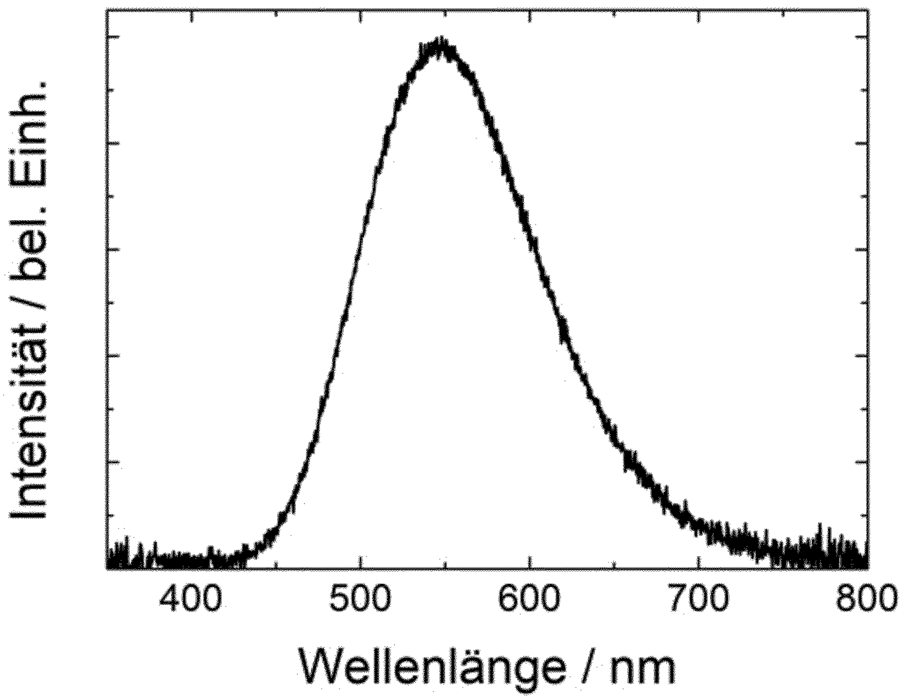

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2010149748 A1
- WO 2013014066 A1
- DE 10317556 A1


### In der Beschreibung aufgeführte Nicht-Patentliteratur


- **H. YERSIN.** *Top. Curr. Chem.,* 2004, vol. 241, 1
- **H. YERSIN.** Highly Efficient OLEDs with Phosphorescent Materials. Wiley-VCH, 2008
- **D. VOLZ et al.** *Inorg. Chem. Commun.,* 2013, vol. 37, 106
- **H. ARAKI ; K. TSUGE ; Y. SASAKI ; S. ISHIZAKA ; N. KITAMURA.** *Inorg. Chem.,* 2007, vol. 46, 10032
- **D. M. ZINK et al.** *Chem. Mat.,* 2013, vol. 25, 4471
- **D. VOLZ et al.** *Chem. Mater.,* 2013, vol. 25, 3414
- **D. VOLZ.** *Chem. Mater.,* 2013, vol. 25, 3414
- **ARAKI, H. ; TSUGE, K. ; SASAKI, Y. ; ISHIZAKA, S. ; KITAMURA, N. ; LIGANDS, N. ; BR, N.** *X. Inorg. Chem.,* 2005, vol. 44, 9667
- **LEITL, M. J. ; KÜCHLE, F. R. ; MAYER, H. A ; WESEMANN, L. ; YERSIN, H.** *J. Phys. Chem. A,* 2013, vol. 117, 11823